# EUROPEAN PATENT APPLICATION

(11) **EP 4 697 912 A1**
(43) Date of publication of application: **18.02.2026**
(21) Application number: 25172915.8
(22) Date of filing: 28.04.2025
(51) Int. Cl.: H10K 50/818, H10K 50/856

(54) **DISPLAY DEVICE**

(30) Priority: 14.08.2024 KR 20240108892
(71) Applicant: LG Display Co., Ltd., Seoul, 07336 (KR)
(72) Inventor: JUNG, Seyeon, 10845 Gyeonggi-do (KR); KIM, JeongOh, 10845 Gyeonggi-do (KR); YU, Jaechoul, 10845 Gyeonggi-doi (KR)
(74) Representative: Ter Meer Steinmeister & Partner

(57) **Abstract**

A display device can include a substrate including a plurality of sub-pixels, a first planarization layer disposed on the substrate, a structure disposed on the first planarization layer and having a tapered side portion, an anode disposed on the structure and the first planarization layer, a bank disposed on a part of the anode and having a first opening, an organic layer to emit light and being exposed through the first opening and disposed on the anode, and a cathode disposed on the organic layer.

## Description

This application claims priority to Korean Patent Application No. 10-2024-0108892 filed on August 14, 2024, in the Korean Intellectual Property Office.

### BACKGROUND

### Field

The present disclosure relates to a display device.

### Discussion of the Related Art

Currently, a field of a display device has been rapidly developed and studies are continued to improve performances of various display devices, such as reduced thickness, light weight, and low power consumption. Such improvements in the display device provides improved expression of electrical information signals to visually information.

Among various display devices, an electroluminescent display device is one that is self-emitting display device that does not require a separate light source, which is in contrast to a liquid crystal display device that requires a separate light source, such as a backlight unit. Therefore, the electroluminescent display device can be manufactured to have light weight and reduced thickness. Since the electroluminescent display device can be driven at a low voltage, it is advantageous not only in terms of power consumption, but also in terms of color implementation, a response speed, a viewing angle, a contrast ratio (CR). Therefore, it is expected that the self-emitting display device will be continued to be utilized in various fields.

### SUMMARY OF THE DISCLOSURE

A top emission type electroluminescent display device uses a transmissive material as a cathode to upwardly emit light emitted from a light emitting layer. Even though the cathode has a transmissive characteristic, some of light emitted from the light emitting layer is reflected from the cathode to be directed to the anode and reflected from the anode again. Therefore, light is repeatedly reflected back and forth between the anode and the cathode. In this case, a micro cavity, in which luminance is improved by constructive interference of light having a specific wavelength, among light emitted from the light emitting layer, based on the distance between the anode and the cathode, can be implemented.

Therefore, the inventors of the present disclosure recognized that when the micro cavity is implemented to improve an optical efficiency, a front surface luminance is increased so that the optical efficiency of the front surface is improved. However, the inventors of the present disclosure also recognized that when the micro cavity is implemented, a luminance viewing angle is reduced since the amount of diagonally directed light relatively decreases as the amount of light toward the front surface increases.

Therefore, the inventors of the present disclosure invented a display device with a new structure which can implement the micro cavity and also improve the viewing angle dependency, which causes luminance changes and color shifts in accordance with the viewing angle.

Therefore, an object of the disclosure is to provide a display device which can increase the front surface luminance and also improve the luminance viewing angle.

Further, another object of the disclosure is to provide a display device which can improve the amount of light extraction and thus further increase the front surface luminance.

Objects of the present disclosure are not limited to the above-mentioned objects, and other objects, which are not mentioned above, can be clearly understood by those skilled in the art from the following descriptions.

The object is solved by the features of the independent claims. Preferred embodiments are given in the dependent claims.

A display device of an embodiment of the disclosure includes a substrate including a plurality of sub-pixels, a first planarization layer disposed over the substrate, a structure disposed on the first planarization layer and having a tapered side portion, an anode disposed on the structure and the first planarization layer, a bank covering a part of the anode and having a first opening, an organic layer exposed through the first opening and disposed on the anode and a cathode disposed on the organic layer.
**In** another aspect a display device is provided comprising: a substrate including a plurality of sub-pixels; a planarization layer on the substrate; a structure on the planarization layer and having a tapered side portion; and a light emitting element on the structure, and configured to emit light, wherein the light emitting element emits light in a first direction that is perpendicular to the substrate, and a second direction that is angled to the substrate.

In one or more embodiments, the side portion may include a taper with an angle less than 30°.

The structure can have a smaller height than the bank.

In one or more embodiments, the structure may further include a planar portion that is parallel to the substrate.

In one or more embodiments, the organic layer may be denoted as organic light emitting layer.

In one or more embodiments, the tapered side portion may be located at a periphery of the planar portion.

In one or more embodiments, the planar portion may have a height greater than that of the tapered side portion.

In one or more embodiments, the display device may further comprise a groove formed in the first planarization layer.

In one or more embodiments, a portion of the anode may be located in the groove.

In one or more embodiments, an end of the tapered side portion may be in the groove.

In one or more embodiments, the first opening may be rectangular.

In one or more embodiments, a portion of the anode may extend between the first planarization layer and the bank.

In one or more embodiments, the tapered side portion may include a taper having an angle of less than 30°.

In one or more embodiments, the taper may have a width that is approximately 2 µm to 6 µm.

In one or more embodiments, the taper may be disposed under a light emitting element including the anode, the organic layer and the cathode.

In one or more embodiments, the structure may have a smaller height than the bank.

In one or more embodiments, the structure may include a curved top surface disposed under the light emitting element.

In one or more embodiments, the anode may have a side mirror structure.

In one or more embodiments, an end of the side mirror structure may be disposed between the bank and the first planarization layer.

In one or more embodiments, an angle of the side mirror structure may be roughly 30°- 60°.

In one or more embodiments, an angle of the taper may be less than the angle of the side mirror structure.

In one or more embodiments, the structure may include a plurality of structures that are separated from each other.

In one or more embodiments, the plurality of structures may include a first structure, and a second structure.

In one or more embodiments, the second structure may encircle the first structure.

In one or more embodiments, at least one of the first and second structures may include an insulating material.

In one or more embodiments, the insulating material may have a hardness that is greater than that of the first planarization layer.

In one or more embodiments, the display device may further comprise a second planarization layer on the first planarization layer.

In one or more embodiments, an end of the anode may be on the second planarization layer.

In one or more embodiments, the display device may further comprise a second opening in the second planarization layer.

In one or more embodiments, the second opening may be greater in size than a first opening of the first planarization layer.

In one or more embodiments, the display device may further comprise a reflecting structure to reflect the light in a third direction that is different from the first direction and the second direction.

Other detailed matters of the example embodiments are included in the detailed description and the drawings.

In the display device of an embodiment of the disclosure, a structure including a taper having an angle of less than 30° is disposed under a light emitting element. Thus, it is possible to provide the display device which can increase the front surface luminance and also improve the luminance viewing angle.

In the display device of an embodiment of the disclosure, the structure having a flat top surface is disposed under the light emitting element. Thus, it is possible to provide the display device which can increase the front surface luminance and also reduce a rainbow reflectance depending on reflection of external light.

In the display device of an embodiment of the disclosure, an anode has a side mirror structure. Thus, it is possible to increase the amount of light extraction of the display device. Therefore, it is possible to implement low power consumption. Further, it is possible to reduce the use of fossil fuels for power generation and thus possible to reduce the emission of greenhouse gases. Accordingly, it is possible to implement ESG (Environment/Social/Governance).

In the display device according to an example embodiment of the present disclosure, a dual tapered portion is provided by etching a part of a thickness of a planarization layer under the structure, which results in an increase in length of the taper. Thus, it is possible to maximize the viewing angle efficiency.

The effects according to the present disclosure are not limited to the contents exemplified above, and more various effects are included in the present disclosure.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a diagram schematically illustrating a configuration of a display device according to embodiments of the present disclosure;
FIG. 2 is a circuit diagram of a sub-pixel in the display device of FIG. 1;
FIG. 3 is a cross-sectional view illustrating a part of a display panel according to a first embodiment of the present disclosure;
FIG. 4 is an enlarged view of the part A of FIG. 3;
FIG. 5 is a plan view illustrating a sub-pixel structure in the display panel of FIG. 3;
FIG. 6A and FIG. 6B are photographs showing, by way of example, a thickness distribution of an organic layer depending on a taper of a structure;
FIG. 7 is a graph showing a luminous intensity depending on a viewing angle;
FIG. 8 is a cross-sectional view illustrating a part of a display panel according to a second embodiment of the present disclosure;
FIG. 9 is an enlarged view of the part B of FIG. 8;
FIG. 10 is a plan view illustrating a sub-pixel structure in the display panel of FIG. 8;
FIG. 11 is a graph showing a luminous intensity depending on a viewing angle;
FIG. 12 is a cross-sectional view illustrating a part of a display panel according to a third embodiment of the present disclosure;
FIG. 13 is an enlarged view of the part C of FIG. 12;
FIG.14 diagram illustrating a planar surface structure of a sub-pixel in the display panel of FIG. 12;
FIG. 15 is a graph showing a luminous intensity depending on a viewing angle;
FIG. 16 is a graph for comparison with the graph in FIG. 15 in terms of a luminous intensity and an integrated intensity area depending on an angle;
FIG. 17 is a graph showing a luminous intensity depending on a viewing angle;
FIG. 18 is a graph showing a luminous intensity depending on a viewing angle;
FIG. 19 is a cross-sectional view illustrating a part of a display panel according to a fourth embodiment of the present disclosure;
FIG. 20 is an enlarged view of the part D of FIG. 19;
FIG.21 diagram illustrating a planar surface structure of a sub-pixel in the display panel of FIG.19;
FIG. 22 is a cross-sectional view illustrating a part of a display panel according to a fifth embodiment of the present disclosure;
FIG. 23 is an enlarged view of the part E of FIG. 22;
FIG. 24 diagram illustrating a planar surface structure of a sub-pixel in the display panel of FIG. 22;
FIG. 25 is a cross-sectional view illustrating a part of a display panel according to a sixth embodiment of the present disclosure;
FIG. 26 is an enlarged view of the part F of FIG. 25;
FIG. 27 diagram illustrating a planar surface structure of a sub-pixel in the display panel of FIG. 25;
FIG. 28 is an enlarged partial cross-sectional view illustrating a part of a display panel according to a seventh embodiment of the present disclosure.

### DETAILED DESCRIPTION OF THE EMBODIMENTS

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Like reference numerals generally denote like elements throughout the disclosure. Further, in the following description of the present disclosure, a detailed explanation of known related technologies may be omitted or may be provided briefly to avoid unnecessarily obscuring the subject matter of the present disclosure. The terms such as "including," "having," and "consist of" used herein are generally intended to allow other components to be added unless the terms are used with the term "only". Any references to singular can include plural unless expressly stated otherwise.

Components are interpreted to include an ordinary error range even if not expressly stated.

When the position relation between two parts is described using the terms such as "on", "above", "below", and "next", one or more parts can be positioned between the two parts unless the terms are used with the term "immediately" or "directly".

When an element or layer is disposed "on" another element or layer, another layer or another element can be interposed directly on the other element or therebetween.

Although the terms "first", "second", and the like are used for describing various components, these components are not confined by these terms. These terms are merely used for distinguishing one component from the other components. Therefore, a first component to be mentioned below can be a second component in a technical concept of the present disclosure.

Like reference numerals generally denote like elements throughout the disclosure.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

The term "can" fully encompasses all the meanings and coverages of the term "may."

The term "made of" for an element can fully encompass the meaning of being completely formed of the element, or simply including the element.

Hereinafter, example embodiments of the present disclosure will be described in detail with reference to the drawings.

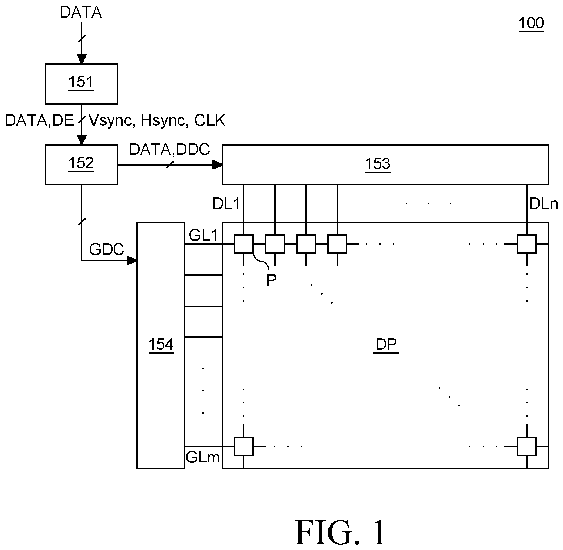

FIG. 1 is a diagram schematically illustrating a configuration of a display device according to embodiments of the present disclosure. All components of each display device according to all embodiments of the present disclosure are operatively coupled and configured.

Referring to FIG. 1, a display device 100 according to embodiments of the disclosure can include an image processor 151, a timing controller 152, a data driver 153, a gate driver 154, and a display part DP.

First, the image processor 151 can output a data signal DATA, a data enable signal DE, etc. supplied from the outside. The image processor 151 can output one or more of a vertical sync signal (Vsync), a horizontal sync signal (Hsync), and a clock signal (Clk) in addition to the data enable signal DE.

The timing controller 152 receives the data signal DATA and driving signals including the data enable signal DE or the vertical sync signal, the horizontal sync signal, the clock signal, etc. from the image processor 151. The timing controller 152 can output a gate timing control signal GDC for controlling operation timing of the gate driver 154 and a data timing control signal DDC for controlling operation timing of the data driver 153 based on the driving signals.

Further, the data driver 153 samples and latches the data signal DATA received from the timing controller 152 in response to the data timing control signal DDC received from the timing controller 152. Then, the data driver 153 converts the sampled and latched data signal DATA into a gamma reference voltage. The data driver 153 can output the data signal DATA through data lines DL1 to DLn, where n is a real number.

Further, the gate driver 154 can output a gate signal while shifting a level of a gate voltage in response to the gate timing control signal GDC received from the timing controller 152. The gate driver 154 can output the gate signal through gate lines GL1 to GLm, where m is a real number.

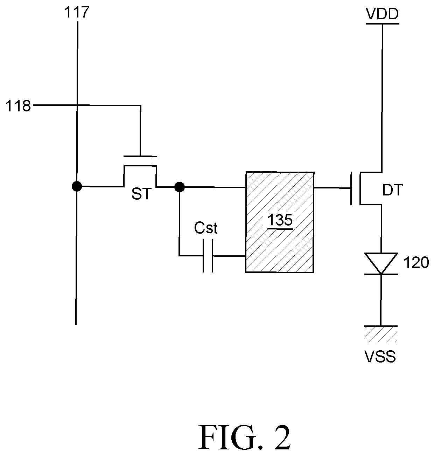

The display part DP can display an image in response to the data signal DATA and the gate signal received from the data driver 153 and the gate driver 154, respectively, while a sub-pixel P emits light. A detailed structure of the sub-pixel P will be described with reference to FIG. 2 through FIG. 5.

FIG. 2 is a circuit diagram of a sub-pixel in the display device of FIG. 1.

Referring to FIG. 2, a sub-pixel of the display device according to embodiments of the disclosure can include a switching transistor ST, a driving transistor DT, a compensation circuit 135, and a light emitting element 120.

The light emitting element 120 emits light depending on a driving current formed by the driving transistor DT.

The switching transistor ST performs a switching operation so that a data signal supplied through a data line 117 is stored in a capacitor Cst as a data voltage in response to a gate signal supplied through a gate line 118.

The driving transistor DT enables the constant driving current to flow between a high-potential power line VDD and a low-potential power line VSS in response to the data voltage stored in the capacitor Cst.

The compensation circuit 135 is a circuit configured to compensate for a threshold voltage of the driving transistor DT. The compensation circuit 135 can include one or more thin film transistors and capacitors. The configuration of the compensation circuit 135 can vary depending on a compensation manner.

The sub-pixel shown in FIG. 2 is implemented as 2T1C structure, where 2T (two Transistors) and 1C (one Capacitor) are provided as the switching transistor ST, the driving transistor DT, and the capacitor Cst. Also, the light emitting element 120 is provided in the sub-pixel. When the compensation circuit 135 is added, the sub-pixel can be implemented as various structures, such as 3T1C, 4T2C, 5T2C, 6T1C, 6T2C, 7T1C, 7T2C, and the like.

Hereinafter, the configuration of the sub-pixel will be described in detail with reference to the accompanying drawings.

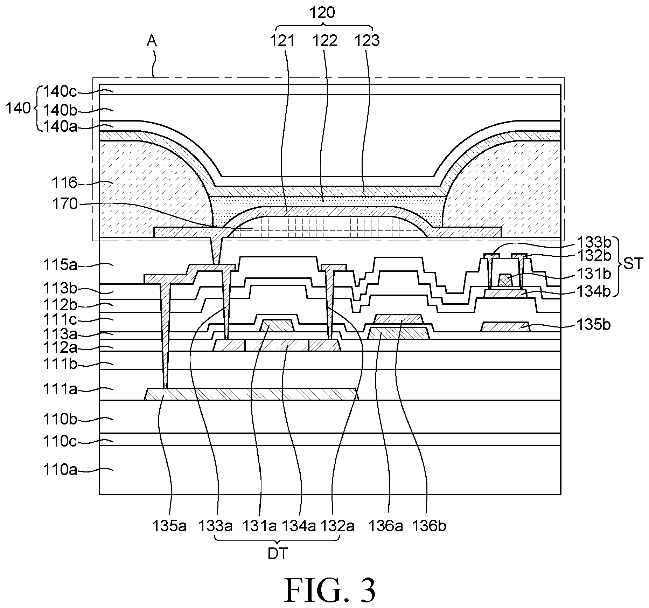

FIG. 3 is a cross-sectional view illustrating a part of a display panel according to a first embodiment of the present disclosure.

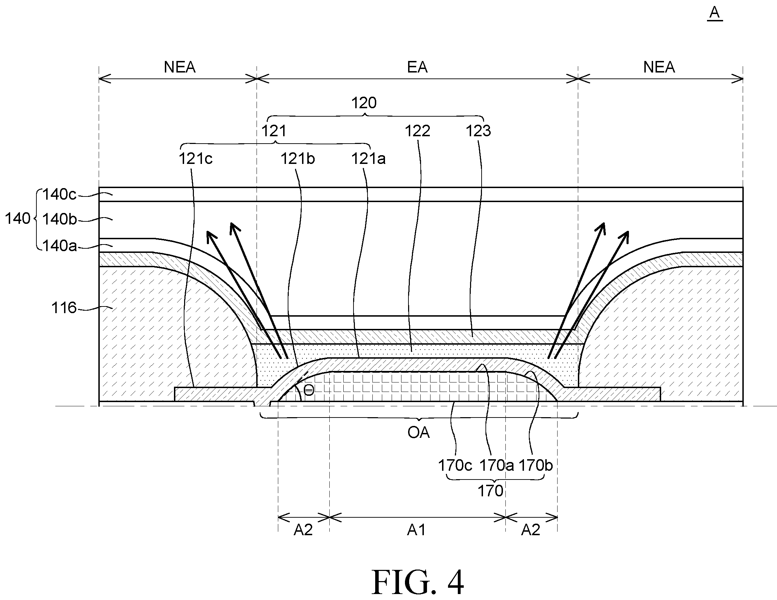

FIG. 4 is an enlarged view of the part A of FIG. 3.

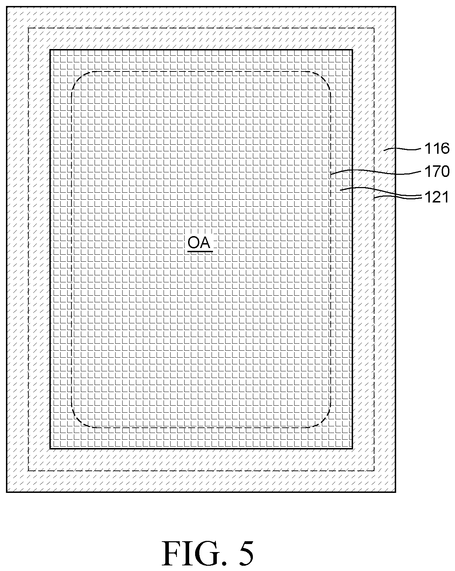

FIG. 5 is a plan view illustrating a sub-pixel structure in the display panel of FIG. 3.

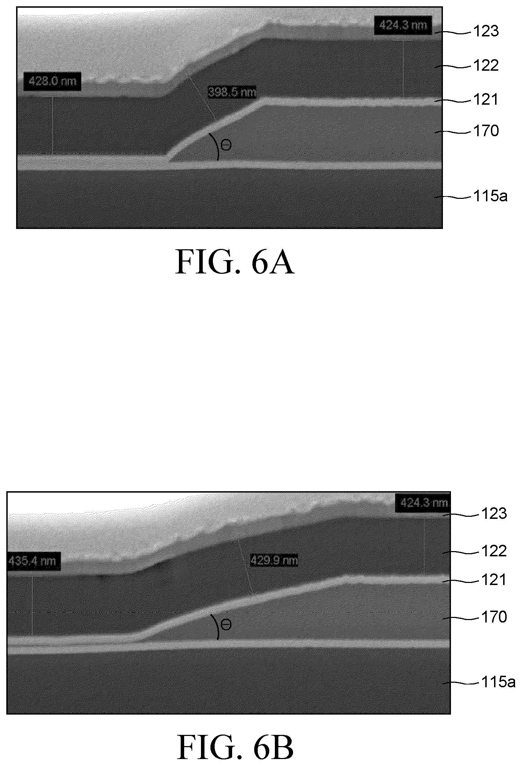

FIG. 6A and FIG. 6B are photographs showing, by way of example, a thickness distribution of an organic layer depending on a taper of a structure.

Particularly, FIG. 3 and FIG. 4 are cross-sectional views illustrating a sub-pixel as examples.

Referring to FIG. 3 and FIG. 4 an encapsulation layer 140 is disclosed. The sub-pixel can include a touch sensor layer and/or a color filter layer and a black matrix on the encapsulation layer 140. But is not limited thereto.

Particularly, FIG. 5 illustrates a planar surface structure of a sub-pixel including a bank 116 having an opening OA, a structure 170, and an anode 121 on the structure 170.

Further, FIG. 6A is a photograph showing a thickness distribution of an organic layer 122 when the structure 170 has a taper angle of 30°. FIG. 6B is a photograph showing a thickness distribution of the organic layer 122 when the structure 170 has a taper angle of 20°.

The display panel according to the first embodiment of the disclosure can include a pixel area in which a plurality of sub-pixels is disposed, and a wiring area in which various signal lines are disposed.

A plurality of first sub-pixels, second sub-pixels and third sub-pixels can be disposed in the pixel area. For example, a first sub-pixel can be a red sub-pixel. For example, a second sub-pixel can be a green sub-pixel. For example, a third sub-pixel can be a blue sub-pixel. But the disclosure is not limited thereto.

For example, each of the first sub-pixel, the second sub-pixel, and the third sub-pixel can have a polygonal shape, such as a rectangular shape, but is not limited thereto. Each of the first sub-pixel, the second sub-pixel, and the third sub-pixel can have various shapes, such as a circular shape or an oval shape. But the disclosure is not limited thereto.

Herein, the shape of the opening OA defines the shape of the sub-pixel. However, the disclosure is not limited thereto.

Referring to FIG. 3 through FIG. 5, the driving transistor DT, the switching transistor ST, and the light emitting element 120 can be disposed on substrates 110a, 110b and 110c according to the first embodiment of the disclosure.

For example, the substrates 110a, 110b and 110c can include a first substrate 110a, a second substrate 110b, and an interlayer insulating film 110c, but the disclosure is not limited thereto. The interlayer insulating film 110c can be disposed between the first substrate 110a and the second substrate 110b.

As described above, the substrate include the first substrate 110a, the second substrate 110b, and the interlayer insulating film 110c. by having this multilayered structure, it is possible to suppress the permeation of moisture. For example, the first substrate 110a and the second substrate 110b can be polyimide (PI) substrates, but the disclosure is not limited thereto. The substrates 110a, 110b and 110c can be made of a flexible material so as to be flexible substrates. In this case, it is possible to manufacture a foldable display panel which can be folded or bent. But the disclosure is not limited thereto.

A plurality of transistors, such as the driving transistor DT, the switching transistor ST, etc., can be disposed on the substrate 110a, 110b and 110c.

On top of the substrate, there might be a buffer layer. The buffer layer may include a multi-buffer layer 111a. The buffer layer can be disposed on the second substrate 110b.

An active buffer layer 111b can be disposed on the buffer layer 111a.

Meanwhile, a first light shielding layer 135a can be disposed on the second substrate 110b. However, the present disclosure is not limited thereto, and the first light shielding layer 135a can be disposed on the multi-buffer layer 111a.

The first light shielding layer 135a can serve to shield light.

The multi-buffer layer 111a can be disposed on the first light shielding layer 135a.

The active buffer layer 111b can be disposed on the multi-buffer layer 111a.

A first active layer 134a of the driving transistor DT can be disposed on the active buffer layer 111b.

A first gate insulating film 112a can be disposed on the first active layer 134a.

Further, a first gate electrode 131a of the driving transistor DT can be disposed on the first gate insulating film 112a.

Further, for example, a gate material layer 136a can be disposed on the first gate insulating film 112a at a location different from a location where the driving transistor DT is disposed. For example, the gate material layer 136a can be a first storage electrode, but is not limited thereto.

A first interlayer insulating film 113a can be disposed on the first gate electrode 131a.

A metal layer 136b can be disposed on the first interlayer insulating film 113a. For example, the metal layer 136b can be a second storage electrode, but is not limited thereto.

In this case, the metal layer 136b constitutes a storage capacitor together with the gate material layer 136a. However, the disclosure is not limited thereto.

Further, for example, a second light shielding layer 135b can be disposed on the first interlayer insulating film 113a at a location different from a location where the metal layer 136b is disposed, but is not limited thereto.

A further buffer layer 111c can be disposed on the metal layer 136b and the second light shielding layer 135b.

A second active layer 134b of the switching transistor ST can be disposed on the further buffer layer 111c.

A second gate insulating film 112b can be disposed on the second active layer 134b.

Further, a second gate electrode 131b of the switching transistor ST can be disposed on the second gate insulating film 112b.

A second interlayer insulating film 113b can be disposed on the second gate electrode 131b.

A first source electrode 132a and a first drain electrode 133a of the driving transistor DT can be disposed on the second interlayer insulating film 113b. Further, a second source electrode 132b and a second drain electrode 133b of the switching transistor ST can be disposed on the second interlayer insulating film 113b.

In this case, for example, the first source electrode 132a and the first drain electrode 133a can be electrically connected to one side and the other side, respectively, of the first active layer 134a through contact holes formed in the second interlayer insulating film 113b, the second gate insulating film 112b, the buffer layer 111c, the first interlayer insulating film 113a, and the first gate insulating film 112a.

Further, for example, a part of the first drain electrode 133a can be electrically connected to one side of the first light shielding layer 135a through a contact hole formed in the second interlayer insulating film 113b, the second gate insulating film 112b, the buffer layer 111c, the first interlayer insulating film 113a, the first gate insulating film 112a, the active buffer layer 111b, and the multi-buffer layer 111a.

Further, for example, the second source electrode 132b and the second drain electrode 133b can be electrically connected to one side and the other side, respectively, of the second active layer 134b through contact holes formed in the second interlayer insulating film 113b and the second gate insulating film 112b.

A portion of the first active layer 134a overlapping the first gate electrode 131a serves as a channel region. For example, one of the first source electrode 132a and the first drain electrode 133a can be connected to one side of the channel region of the first active layer 134a. Further, the other can be connected to the other side of the channel region of the first active layer 134a.

Further, a portion of the second active layer 134b overlapping the second gate electrode 131b serves as a channel region. For example, one of the second source electrode 132b and the second drain electrode 133b can be connected to one side of the channel region of the second active layer 134b. Further, the other can be connected to the other side of the channel region of the second active layer 134b.

A protection film can be disposed on the first source electrode 132a and the first drain electrode 133a as well as on the second source electrode 132b and the second drain electrode 133b.

A planarization layer 115a can be disposed on the first source electrode 132a and the first drain electrode 133a as well as on the second source electrode 132b and the second drain electrode 133b.

For example, the planarization layer 115a can be referred to as a first planarization layer.

For example, the planarization layer 115a can be made of an organic insulation material, such as benzocyclobutene (BCB) or acrylic resin, but is not limited thereto.

The planarization layer 115a can be disposed on the protection film. The planarization layer 115a is used for levelling the hight differences of the TFT structure and provides a flat surface for applying the light emitting device thereon.

The anode 121 can be disposed on the planarization layer 115a. However, the disclosure is not limited thereto. A connection electrode and a second planarization layer can be disposed on the planarization layer 115a, and the anode 121 can be disposed on the second planarization layer.

Meanwhile, in the first embodiment of the disclosure, the structure 170 can be partially disposed between the planarization layer 115a and the anode 121.

The structure 170 can be disposed under the anode 121. Therefore, the anode 121 can be in contact with the structure 170.

The structure 170 can include a top surface 170a, a side portion 170b, and a bottom surface 170c.

For example, the structure 170 represents protrusion or bulge and/or can be an upwardly convex shape while the bottom surface 170c is flat along a top surface of the planarization layer 115a. Further, for example, the structure 170 includes a central part A1 and an edge part A2. The central part A1 may be denoted as planar portion and has a top surface 170a being flat and substantially parallel to the bottom surface.

The edge part A2 has a side portion 170b includes a taper having a predetermined angle θ. The inclined side portion 170b connects the top surface 170a and the bottom surface 170c.

The structure 170 can have a smaller height than the bank 116.

For example, the structure 170 can be disposed within the opening OA. Further, for example, the structure 170 can have a smaller width and a smaller area than the opening OA when viewed from the top.

The structure 170 may be thicker, in particular in the central part A1, than the anode 121. The anode 121 is fully covering the structure 170. At the edge of the structure 170 the anode 121 contacts the planarization layer 115a. So, the bottom surface 170c of the structure and the lower surface of the anode 121 are on the same level in the circumferential area of the structure 170.

For example, the structure 170 can have an approximately (or overall) polygonal shape, such as a rectangular shape, when viewed from the top, but is not limited thereto. The structure 170 of the present disclosure can have various shapes, such as a circular shape or an oval shape.

As described above, according to the first embodiment of the disclosure, the structure 170 including a taper is disposed under the light emitting element 120. Thus, it is possible to increase a front surface luminance and also improve a luminance viewing angle. For example, when a micro cavity is implemented to improve an optical efficiency, the luminance viewing angle is reduced since the amount of diagonally directed light decreases as the amount of light toward the front surface increases. However, according to the first embodiment of the disclosure, the structure 170 including a taper is disposed corresponding to an edge under the light emitting element 120. Thus, the amount of diagonally directed light increases (see the arrows in FIG. 4). Therefore, it is possible to increase the front surface luminance and also improve the luminance viewing angle.

Herein, the side portion 170b of the structure 170 can include a taper having an angle of less than 30°. When the taper of the side portion 170b of the structure 170 has an angle greater than 30°, the organic layer 122 deposited thereon can have thickness variations, which can cause a reduction in life. For example, when the thickness variations of the organic layer 122 are set to ±5%, the side portion 170b of the structure 170 needs to include a taper having an angle θ of less than 30°. For example, referring to FIG. 6A, it can be seen that when the structure 170 has a taper angle θ of 30°, the organic layer 122 has a thickness variation of 6.9% between the top surface 170a and the side portion 170b. Meanwhile, referring to FIG. 6B, it can be seen that when the structure 170 has a taper angle θ of 20°, the organic layer 122 has a thickness variation of 1.3% between the top surface 170a and the side portion 170b, but is not limited thereto.

Further, according to the first embodiment of the disclosure, the top surface 170a of the structure 170 is flat. Thus, it is possible to increase the front surface luminance and also reduce a rainbow reflectance depending on reflection of external light.

For example, the structure 170 can be made of an organic material. Preferably, the structure 170 can be made of the same organic material, such as benzocyclobutene (BCB) or acrylic resin, as the planarization layer 115a, but is not limited thereto.

Further, for example, the structure 170 can be made of an organic material having a higher hardness than the planarization layer 115a. For example, the structure 170 can be made of the same PI-based material as the bank 116, but is not limited thereto. In this case, the planarization layer 115a having a lower hardness is etched at a higher etching rate than the structure 170 under general dry etching conditions.

For example, the anode 121 can be disposed on a part of the top surface of the planarization layer 115a and the top surface 170a and the side portion 170b of the structure 170. For example, the anode 121 can be disposed in a part of a non-emission area NEA and an emission area EA. Further, the anode 121 disposed in the non-emission area NEA can be in contact with the top surface of the planarization layer 115a. Further, for example, the anode 121 disposed in the emission area EA can be in contact with the top surface of the planarization layer 115a and the top surface 170a and the side portion 170b of the structure 170.

For example, the anode 121 can include a first area 121a which is disposed on the top surface 170a of the structure 170 and whose surface is substantially parallel to a surface of the planarization layer 115a. Further, the anode 121 can include a second area 121b which is disposed on the side portion 170b of the structure 170 and whose surface has a predetermined angle with respect to the planarization layer 115a. The first area 121a of the anode 121 can correspond to the central part A1 of the structure 170.

For example, the second area 121b of the anode 121 can correspond to the edge part A2 of the structure 170. The second area 121b of the anode 121 can be referred to as a side portion of the anode 121.

Further, for example, the anode 121 can include a third area 121c which extends from the second area 121b and whose surface is substantially parallel to the surface of the planarization layer 115a. The third area 121c can correspond to the top surface of the planarization layer 115a. Thus, the anode 121 can include the third area 121c having a flat top surface and partially located within the emission area EA outside the second area 121b having a taper.

Meanwhile, the planarization layer 115a can include at least one contact hole, and the driving transistor DT can be electrically connected to the anode 121 through the contact hole.

The bank 116 can be disposed to cover the anode 121, in particular the edges of the anode 121.

The bank 116 can cover a part of the third area 121c of the anode 121. For example, the bank 116 can cover a part of an edge of the third area 121c of the anode 121.

A portion of the bank 116 can be opened corresponding to the emission area EA of the sub-pixel.

For example, the emission area EA can be referred to as a first emission area.

For example, the bank 116 can include the opening OA provided by removing (opening) a portion corresponding to the emission area EA of each sub-pixel. Further, for example, the opening OA can have an approximately (or overall) polygonal shape, such as a rectangular shape, when viewed from the top, but is not limited thereto. The opening OA of the present disclosure can have various shapes, such as a circular shape or an oval shape.

For example, the opening OA can be referred to as a first opening.

Meanwhile, the emission area EA can correspond in shape to the opening OA. The correspondence of the shape of an element to the shape of another element can mean that the shape of the element is an identical shape to another element, two elements have an identical shape, but have different sizes from each other, or the shape of the element can be formed by transferring the shape of another element. Accordingly, the shape of the emission area EA can mean that the shape of the opening OA is substantially transferred by light emitted from the organic layer 122 located in the opening OA.

Therefore, the emission area EA can have an approximately (or overall) polygonal shape, such as a rectangular shape, when viewed from the top in substantially the same manner as the opening OA, but is not limited thereto. The emission area EA of the present disclosure can have various shapes, such as a circular shape or an oval shape.

Sub-pixels can be distinguished by the emission area EA.

Next, the bank 116 can include a top surface, a side portion, and a bottom surface portion.

For example, the top surface of the bank 116 is the uppermost surface of the bank 116, and can be substantially parallel to the planarization layer 115a.

The side portion of the bank 116 can be a surface extending from the top surface to a side surface of the bank 116. The side portion of the bank 116 can include a taper having a predetermined angle. For example, the side portion of the bank 116 can include a taper having an angle of 30° to 65°. However, the present disclosure is not limited thereto.

Further, for example, the bottom surface portion of the bank 116 can correspond to a surface in contact with the anode 121 in the first area 121a of the anode 121. Further, the bottom surface portion of the bank 116 can correspond to the non-emission area NEA.

For example, the first area 121a and the second area 121b of the anode 121 can be exposed through the opening OA. Further, a part of the third area 121c of the anode 121 can be exposed through the opening OA.

The bank 116 can be made of a PI-based material, but is not limited thereto.

In this case, the side portion of the bank 116 can have a polygonal shape, such as a rectangular shape, when viewed from the top in substantially the same manner as an edge of the opening OA, but is not limited thereto. For example, the side portion of the bank 116 of the present disclosure can have various shapes, such as a circular shape or an oval shape.

For example, the organic layer 122 can be disposed in the opening OA of the bank 116.

For example, the organic layer 122 can be disposed on the first area 121a, the second area 121b, and a part of the third area 121c of the anode 121 exposed through the opening OA.

The organic layer 122 can be disposed only within the opening OA, but the disclosure is not limited thereto. A part of the organic layer 122 can be disposed on the top surface and the side portion of the bank 116 as well as within the opening OA. Further, the organic layer 122 can be disposed to extend to adjacent sub-pixels.

A cathode 123 can be disposed on the organic layer 122.

The light emitting element 120 can be composed of the anode 121, the organic layer 122, and the cathode 123. The organic layer 122 is the layer emitting the light.

The emission area EA can be formed by the light emitting element 120 provided in the opening OA.

The encapsulation layer 140 can be located on the light emitting element 120.

The encapsulation layer 140 can have a single layer structure or a multi-layer structure.

For example, the encapsulation layer 140 can include a first encapsulation layer 140a, a second encapsulation layer 140b, and a third encapsulation layer 140c.

For example, the first encapsulation layer 140a and the third encapsulation layer 140c can be composed of inorganic films, and the second encapsulation layer 140b can be composed of an organic film. For example, among the first encapsulation layer 140a, the second encapsulation layer 140b, and the third encapsulation layer 140c, the second encapsulation layer 140b can be the thickest. Thus, the second encapsulation layer 140b can serve as a planarization layer.

The first encapsulation layer 140a can be made of an inorganic insulating material which can be subjected to low temperature deposition. For example, the first encapsulation layer 140a can be made of silicon nitride (SiNx), silicon oxide (SiOx), silicon oxynitride (SiON), or aluminum oxide (Al2O3). But is not limited thereto.

The second encapsulation layer 140b can be formed to have a smaller area than the first encapsulation layer 140a. In this case, the second encapsulation layer can be formed to expose both ends of the first encapsulation layer 140a.

For example, the second encapsulation layer 140b can be made of an organic insulating material, such as acrylic resin, epoxy resin, polyimide, polyethylene, or silicon oxy carbon (SiOC) but is not limited thereto. Further, for example, the second encapsulation layer 140b can be formed by an inkjet method, but is not limited thereto.

The third encapsulation layer 140c can be formed to cover a top surface and a side surface of each of the second encapsulation layer 140b and the first encapsulation layer 140a.

For example, the third encapsulation layer 140c can minimize or block the permeation of external moisture or oxygen into the first encapsulation layer 140a and the second encapsulation layer 140b. Further, for example, the third encapsulation layer 140c can be made of an inorganic insulating material, such as silicon oxide (SiOx), silicon oxynitride (SiON), aluminum oxide (Al2O3), or silicon nitride (SiNx). But is not limited thereto.

A touch sensor layer and/or a color filter layer and a black matrix can be disposed on the encapsulation layer 140.

In various embodiments, such as with reference to FIGS. 3 and 4, a cross sectional shape of the organic layer 122 is depicted as having a thickness variation that is small at a center and large at a periphery, but is not limited thereto. For example, a thickness variation of the organic layer 122 over the different parts of the anode 121 can be within a specific number, such as 5%. Also, the organic layer 122 can follow a shape of an upper surface of the anode 121, but is not limited thereto.

In various embodiments, such as with reference to FIGS. 3 and 4, a cross section shape of the cathode 123 can be flat across the emission area EA, but is not limited thereto. For example, the cathode 123 can follow a shape of an upper surface of the anode 121 and/or an upper surface of the organic layer 122, but is not limited thereto.

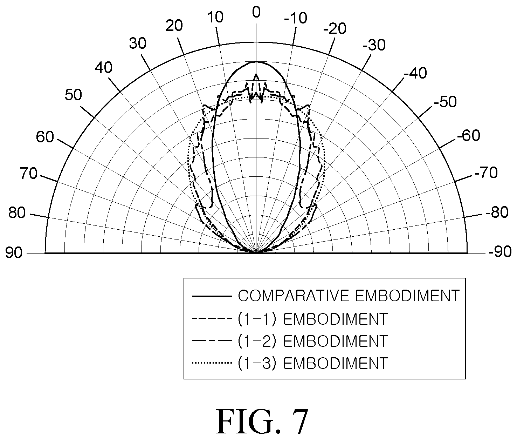

FIG. 7 is a graph showing a luminous intensity depending on a viewing angle.

Particularly, FIG. 7 illustrates a comparative embodiment without a structure. It can be seen that most of light is emitted through a micro cavity.

The first embodiment includes (1-1), (1-2) and (1-3) embodiments respectively including structures with different taper widths. It can be seen that straight light is emitted through a micro cavity and also light is diagonally directed from a side portion of the tapered structure to improve the viewing angle.

As described above, given the thickness variations of the organic layer, the side portion of the structure can include a taper having an angle of less than 30°.

As examples, in the (1-1) embodiment, a taper width is 2 µm and a taper angle is 27°. In the (1-2) embodiment, a taper width is 4 µm and a taper angle is 15°. Further, in the (1-3) embodiment, a taper width is 6 µm and a taper angle is 10°.

Referring to FIG. 7, it can be seen that most of light travels straight due to a strong cavity effect in the comparative embodiment, whereas luminous intensities in a viewing angle direction are improved in the (1-1), (1-2) and (1-3) embodiments.

It can be seen that the (1-1) embodiment where a taper angle is 27° shows a decrease in front light extraction efficiency by about 6.5% as compared to the comparative embodiment. Further, it can be seen that the (1-1) embodiment shows an increase in front light extraction efficiency by about 6.5% as compared to a case where a taper angle is 20°.

It can be seen that the (1-2) embodiment where a taper angle is 15° shows a decrease in front light extraction efficiency by about 13% as compared to the comparative embodiment. Further, it can be seen that the (1-2) embodiment shows a similar front light extraction efficiency to the case where a taper angle is 20°.

It can be seen that the (1-3) embodiment where a taper angle is 10° shows a decrease in front light extraction efficiency by about 14% as compared to the comparative embodiment. Further, it can be seen that the (1-3) embodiment shows a decrease in front light extraction efficiency by about 1% as compared to the case where a taper angle is 20°.

It can be seen that given the thickness variations of the organic layer, a luminance viewing angle is improved when the side portion of the structure includes a taper having an angle of less than 30°. Further, it can be seen that when a taper angle is 10° or 27°, a luminous intensity image shows a Lambertian pattern, which is effective in suppressing viewing angle mura.

The Lambertian pattern is one of patterns that scatter light, and shows that intensities of light reflected from the surface are uniformly distributed in all directions regardless of an incident angle. A surface having such properties can be referred to as a Lambertian surface.

Further, it can be seen that given the front light extraction efficiency, the effect is the greatest when a taper angle is 27°.

Meanwhile, according to the present disclosure, a dual tapered portion is provided by etching a part of a thickness of a planarization layer under the structure. This will be described in detail with reference to a second embodiment of the present disclosure.

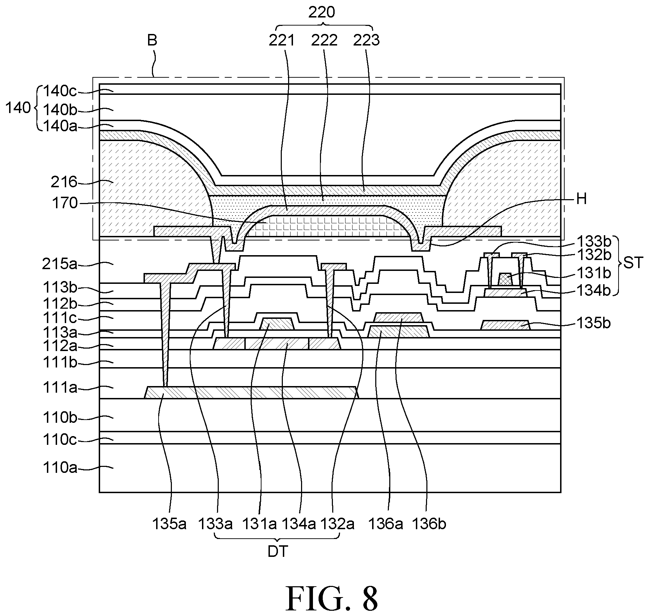

FIG. 8 is a cross-sectional view illustrating a part of a display panel according to the second embodiment of the present disclosure.

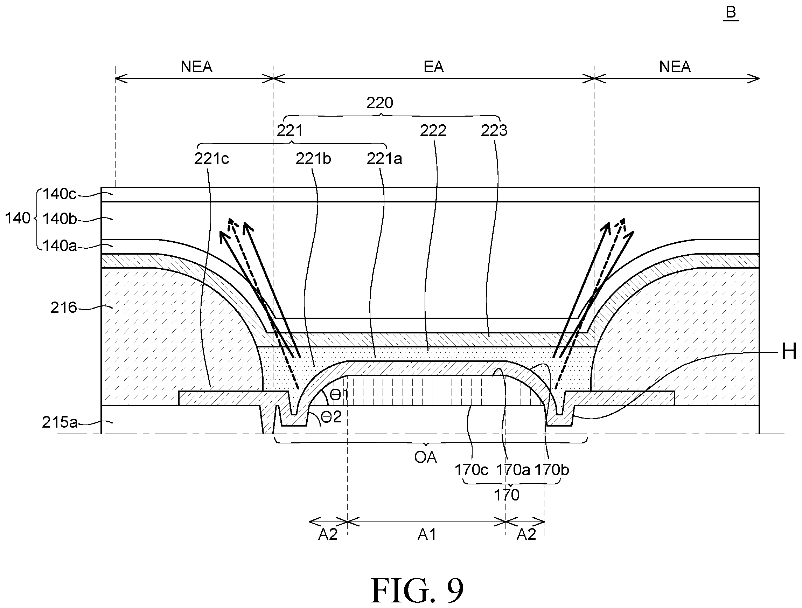

FIG. 9 is an enlarged view of the part B of FIG. 8.

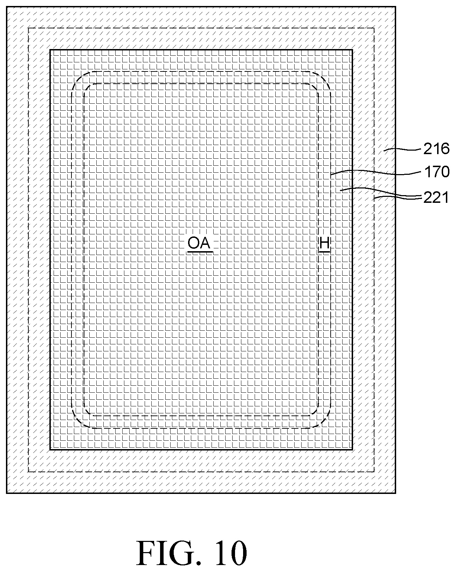

FIG. 10 is a plan view illustrating a sub-pixel structure in the display panel of FIG. 8.

Particularly, FIG. 8 and FIG. 9 are cross-sectional views of a sub-pixel as examples.

Referring to FIG. 8 and FIG. 9, the sub-pixel can include a touch sensor layer and/or a color filter layer and a black matrix on the encapsulation layer 140.

FIG. 10 illustrates a planar surface structure of a sub-pixel including a bank 216 having the opening OA, the structure 170, an anode 221 on the structure 170, and a cathode 223 on the organic layer 222.

The second embodiment of present disclosure shown in FIG. 8 through FIG. 10 is substantially the same as the first embodiment shown in FIG. 3 through FIG. 5 only except that a dual tapered portion is provided by etching a part of a thickness of a planarization layer 215a under the structure 170. Therefore, redundant description of the same components will be omitted. Hereinafter, description of the same reference numerals can refer to FIG. 1 through FIG. 5.

Referring to FIG. 8 through FIG. 10, the driving transistor DT, the switching transistor ST, and a light emitting element 220 can be disposed on the substrates 110a, 110b and 110c according to the second embodiment of the present disclosure.

The planarization layer 215a can be disposed on the driving transistor DT and the switching transistor ST.

For example, the planarization layer 215a can be referred to as a first planarization layer.

The planarization layer 215a according to the second embodiment of the present disclosure includes a groove H provided by removing a part of a thickness of a top surface. For example, the groove H can be patterned simultaneously while the structure 170 is patterned. However, the present disclosure is not limited thereto.

The groove H can have a flat bottom surface, but is not limited thereto.

For example, the groove H can be provided along an edge of the emission area EA or the opening OA, but is not limited thereto. Further, for example, the groove H can have a frame shape along an inner edge of the opening OA when viewed from the top, but is not limited thereto. For example, the groove H can have an approximately (or overall) polygonal annular shape, such as a rectangular shape, corresponding in shape to the opening OA when viewed from the top, but is not limited thereto. The groove H of the present disclosure can have various shapes, such as a circular shape or an oval annular shape. But is not limited thereto.

For example, a depth of the groove H can be smaller than a height of the planarization layer 215a. However, the present disclosure is not limited thereto.

The structure 170 can be disposed on the planarization layer 215a.

As described above, the structure 170 can include the top surface 170a, the side portion 170b, and the bottom surface 170c.

For example, the structure 170 includes the central part A1 where the top surface 170a is flat and the edge part A2 where the side portion 170b includes a taper having a first angle □ 1 and the top surface 170a extends to the bottom surface. For example, the side portion 170b of the structure 170 can include a taper having the first angle θ1 of less than 30°.

The structure 170 can have a smaller height than the bank 116.

For example, the structure 170 can be disposed within the opening OA. Further, for example, the structure 170 can have a smaller width and a smaller area than the opening OA when viewed from the top. Further, the groove H can be disposed outside the structure 170 along an edge of the structure 170.

For example, the structure 170 can have an approximately (or overall) polygonal shape, such as a rectangular shape, when viewed from the top, but is not limited thereto. The structure 170 of the present disclosure can have various shapes, such as a circular shape or an oval shape. But is not limited thereto.

As described above, according to the second embodiment of the present disclosure, the structure 170 including a taper having the first angle θ1 is disposed at an edge under the light emitting element 220. Thus, the amount of diagonally directed light increases (see the solid arrows in FIG. 9). Therefore, it is possible to increase the front surface luminance and also improve the luminance viewing angle.

Herein, given the thickness variations of an organic layer 222, the side portion 170b of the structure 170 can include a taper having the first angle θ1 of less than 30°.

Further, according to the second embodiment of the present disclosure, the top surface 170a of the structure 170 is flat. Thus, it is possible to increase the front surface luminance and also reduce the rainbow reflectance depending on reflection of external light.

For example, the structure 170 can be made of the same organic material, such as benzocyclobutene (BCB) or acrylic resin, as the planarization layer 215a, but is not limited thereto.

Further, for example, the structure 170 can be made of an organic material having a higher hardness than the planarization layer 215a. For example, the structure 170 can be made of the same PI-based material as the bank 216, but is not limited thereto. In this case, the planarization layer 215a having a lower hardness is etched at a higher etching rate than the structure 170 under general dry etching conditions. Therefore, when the groove H is patterned, a horizontal etching rate of the structure 170 is higher than a vertical etching rate of the planarization layer 215a. Thus, a taper of the groove H can be increased. As a result, a dual tapered portion can be formed between the side portion 170b of the structure 170 and the groove H. For example, the groove H can include a taper having a second angle θ2, which is different from that of the taper of the side portion 170b, along the taper of the side portion 170b, but is not limited thereto. For example, when the side portion 170b of the structure 170 includes a taper having the first angle θ1 of less than 30°, the groove H can include a taper having the second angle θ2 of 30° or more.

Meanwhile, the structure 170 is made of an organic material and thus has a higher surface roughness than an inorganic material. Therefore, the light emitting element 220 can be improved in efficiency as compared to the inorganic material.

As described above, according to the second embodiment of the present disclosure, a dual tapered portion is provided by etching a part of a thickness of the planarization layer 215a under the structure 170. The length of the taper is substantially increased. Further, the groove H including a taper having the second angle θ2 is disposed at an edge under the light emitting element 220. Thus, the amount of diagonally directed light further increases (see the dashed arrows in FIG. 9). As a result, it is possible to improve the luminance viewing angle by the structure 170 including a taper having the first angle θ1 and further improve the luminance viewing angle by the groove H including a taper having the second angle θ2.

The anode 221 can be disposed on a part of a top surface of the planarization layer 215a, within the groove H, and on the top surface 170a and the side portion 170b of the structure 170. For example, the anode 221 can be disposed in the emission area EA and a part of the non-emission area NEA. Further, the anode 221 disposed in the non-emission area NEA can be in contact with the top surface of the planarization layer 215a. Further, for example, the anode 221 disposed in the emission area EA can be in contact with the inside of the groove H and with the top surface 170a and the side portion 170b of the structure 170.

For example, the anode 221 can include a first area 221a which is disposed the top surface 170a of the structure 170 and whose surface is substantially parallel to a surface of the planarization layer 215a. Further, the anode 221 can include a second area 221b which is disposed on the side portion 170b of the structure 170 and whose surface has a predetermined angle with respect to the planarization layer 215a. For example, the second area 221b of the anode 221 can extend to the inside of the groove H. Thus, a part of the second area 221b of the anode 221 having a flat top surface and extending to the inside of the groove H having a flat bottom surface can be located within the emission area EA.

Further, for example, the anode 221 can include a third area 221c which extends from the second area 221b and whose surface is substantially parallel to the surface of the planarization layer 215a. The third area 221c can correspond to the top surface of the planarization layer 215a.

The bank 216 can be disposed to cover the anode 221.

The bank 216 can cover a part of the third area 221c of the anode 221. For example, the bank 216 can cover a part of an edge of the third area 221c of the anode 221.

The bank 216 can be disposed outside the groove H. For example, the bank 216 can be disposed outside the groove H to be spaced apart from each other, but is not limited thereto.

A portion of the bank 216 can be opened corresponding to the emission area EA of the sub-pixel.

For example, the bank 216 can include the opening OA provided by removing (opening) a portion corresponding to the emission area EA of each sub-pixel. The groove H can be disposed in the emission area EA, i.e., within the opening OA. The emission area EA and the opening OA can be wider in the second embodiment than in the first embodiment. Further, for example, the opening OA can have an approximately (or overall) polygonal shape, such as a rectangular shape, when viewed from the top, but is not limited thereto. The opening OA of the present disclosure can have various shapes, such as a circular shape or an oval shape.

Meanwhile, the emission area EA can correspond in shape to the opening OA. Therefore, the emission area EA can have an approximately (or overall) polygonal shape, such as a rectangular shape, when viewed from the top in substantially the same manner as the opening OA, but is not limited thereto. The emission area EA of the present disclosure can have various shapes, such as a circular shape or an oval shape. But is not limited thereto.

The encapsulation layer 140 can be located on the light emitting element 220.

The encapsulation layer 140 can have a single layer structure or a multi-layer structure.

A touch sensor layer and/or a color filter layer and a black matrix can be disposed on the encapsulation layer 140.

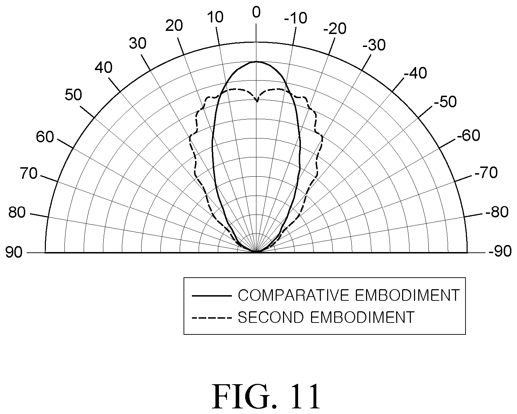

FIG. 11 is a graph showing a luminous intensity depending on a viewing angle.

In the comparative embodiment, a structure is not present. It can be seen that most of light is emitted through a micro cavity.

In the second embodiment, a structure is present and a dual tapered portion is provided by etching a part of a thickness of a planarization layer under the structure. Thus, straight light can be emitted through a micro cavity and the amount of diagonally directed light can be effectively increased by the elongated taper.

Referring to FIG. 11, it can be seen that in the second embodiment, the luminous intensity is greatly increased at a viewing angle of from 30° to 45° due to the dual tapered structure as compared to the comparative embodiment.

It can be seen that in the second embodiment, a luminous intensity image shows a Lambertian pattern, which is effective in suppressing viewing angle mura.

Meanwhile, according to the present disclosure, an anode has a side mirror structure, and, thus, it is possible to increase the amount of light extraction of the display device. This will be described in detail with reference to the accompanying drawings.

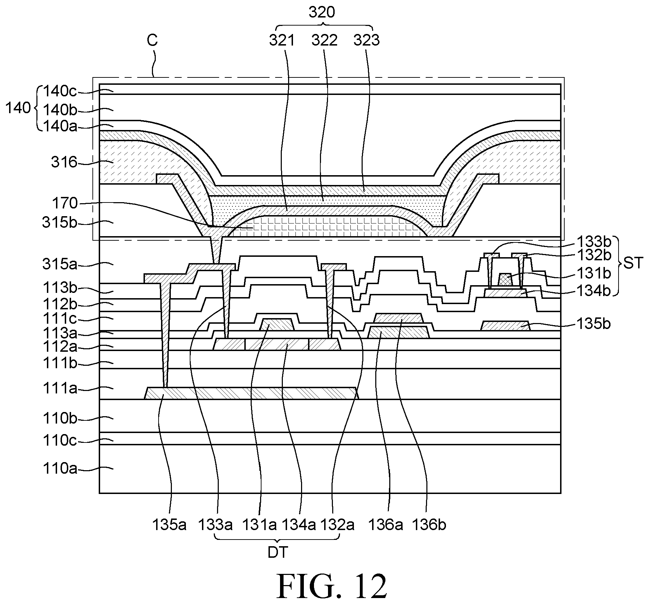

FIG. 12 is a cross-sectional view illustrating a part of a display panel according to a third embodiment of the present disclosure.

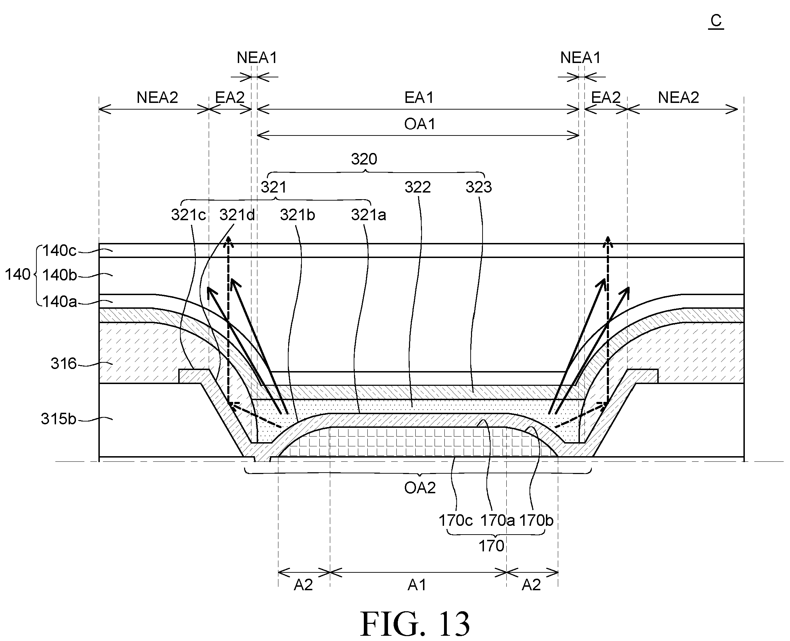

FIG. 13 is an enlarged view of the part C of FIG. 12.

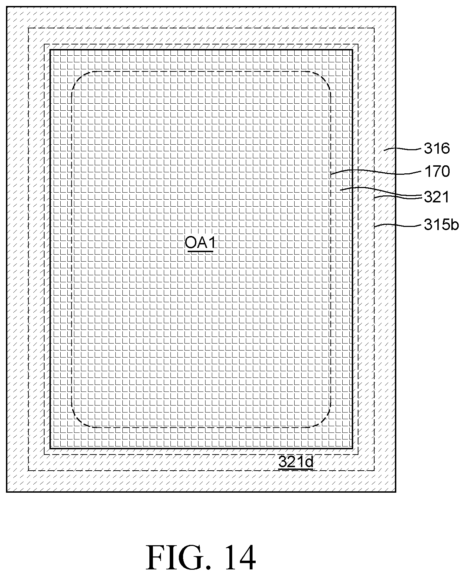

FIG. 14 is a diagram illustrating a planar surface structure of a sub-pixel in the display panel of FIG. 12.

Particularly, FIG. 12 and FIG. 13 are cross-sectional views of a sub-pixel as examples. The sub-pixel can include a touch sensor layer and/or a color filter layer and a black matrix on the encapsulation layer 140. But is not limited thereto.

FIG. 14 illustrates a planar surface structure of a sub-pixel including a bank 316 having a first opening OA1, a second planarization layer 315b, the structure 170, and an anode 321 including a fourth area 321d on the structure 170.

The third embodiment shown in FIG. 12 through FIG. 14 is substantially the same as the first embodiment shown in FIG. 3 through FIG. 5 only except that the anode 321 includes the fourth area 321d having a side mirror structure. Therefore, redundant description of the same components will be omitted. Hereinafter, description of the same reference numerals can refer to FIG. 1 through FIG. 11.

Referring to FIG. 12 through FIG. 14, the driving transistor DT, the switching transistor ST, and a light emitting element 320 can be disposed on the substrates 110a, 110b and 110c according to the third embodiment of the present disclosure.

A first planarization layer 315a can be disposed on the substrates 110a, 110b and 110c.

The structure 170 can be disposed on the first planarization layer 315a.

Description of the structure 170 can refer to the first and second embodiments of the present disclosure described above. As described above, the structure 170 includes the central part A1 where the top surface 170a is flat and the edge part A2 where the side portion 170b includes a taper and the top surface 170a extends to the bottom surface. For example, the side portion 170b of the structure 170 can include a taper having an angle of less than 30°.

The structure 170 can have a smaller height than the bank 316.

Further, the structure 170 can have a smaller height than the second planarization layer 315b.

For example, the structure 170 can be disposed within first and second openings OA1 and OA2. Further, the structure 170 can have a smaller width and a smaller area than the first and second openings OA1 and OA2 when viewed from the top.

For example, the structure 170 can have an approximately (or overall) polygonal shape, such as a rectangular shape, when viewed from the top, but is not limited thereto. The structure 170 of the present disclosure can have various shapes, such as a circular shape or an oval shape.

As described above, according to the third embodiment of the present disclosure, the structure 170 including a taper having an angle of less than 30° is disposed at an edge under the light emitting element 320. Thus, the amount of diagonally directed light increases (see the solid arrows in FIG. 13). Therefore, it is possible to increase the front surface luminance and also improve the luminance viewing angle.

The second planarization layer 315b can be disposed on the first planarization layer 315a.

The second planarization layer 315b can be made of an organic material, such as acrylic-based resin or epoxy-based resin. For example, the second planarization layer 315b can be made of photo acryl (PAC).

For example, the second planarization layer 315b can include the second opening OA2 provided by removing (opening) a portion corresponding to a main emission area EA1 and a first non-emission area NEA1 of the sub-pixel.

The second opening OA2 can have an approximately (or overall) polygonal shape, such as a rectangular shape, when viewed from the top, but is not limited thereto. The second opening OA2 can have various shapes, such as a circular shape or an oval shape. But is not limited thereto.

The structure 170 can be disposed within the second opening OA2.

The second planarization layer 315b can include a top surface and a side portion.

The top surface of the second planarization layer 315b is the uppermost surface of the second planarization layer 315b, and can be substantially parallel to the first planarization layer 315a.

Further, the side portion of the second planarization layer 315b can be a surface extending from the top surface to a side surface of the second planarization layer 315b. For example, the side portion of the second planarization layer 315b can include a taper having a predetermined angle. For example, the side portion of the second planarization layer 315b can include a taper having an angle of 30° to 65°. However, the present disclosure is not limited thereto.

The side portion of the second planarization layer 315b can have an approximately (or overall) polygonal shape, such as a rectangular shape, when viewed from the top in the same manner as an edge of the second opening OA2, but is not limited thereto. The side portion of the second planarization layer 315b can have various shapes, such as a circular shape or an oval shape. But is not limited thereto.

For example, the anode 321 can be on a part of the top surface and the side portion of the second planarization layer 315b, a part of a top surface of the first planarization layer 315a, and the top surface 170a and the side portion 170b of the structure 170. For example, the anode 221 can be disposed in the second opening OA2 and on a part of the top surface and the side portion of the second planarization layer 315b. Further, for example, the anode 221 disposed in the second opening OA2 can be in contact with the top surface of the first planarization layer 315a and the top surface 170a and the side portion 170b of the structure 170.

For example, the anode 321 can include a first area 321a which is disposed on the top surface 170a of the structure 170 and whose surface is substantially parallel to a surface of the first planarization layer 315a. Further, the anode 321 can include a second area 321b which is disposed on the side portion 170b of the structure 170 and whose surface has a predetermined angle with respect to the first planarization layer 315a. For example, the second area 321b of the anode 321 can extend to the top surface of the first planarization layer 315a. The second area 321b of the anode 321 extending to the top surface of the first planarization layer 315a can have a flat top surface.

The first area 321a and the second area 321b of the anode 321 can correspond to the second opening OA2.

For example, the anode 321 can further include a third area 321c which is disposed on the top surface of the second planarization layer 315b and whose surface is substantially parallel to a surface of the second planarization layer 315b. The third area 321c can correspond to the top surface of the second planarization layer 315b.

For example, the anode 321 can further include the fourth area 321d which is disposed on the side portion of the second planarization layer 315b and whose surface has a predetermined angle with respect to the second planarization layer 315b. The fourth area 321d can be disposed between the second area 321b and the third area 321c.

Further, for example, the fourth area 321d of the anode 321 can correspond to the side portion of the second planarization layer 315b. The fourth area 321d of the anode 321 can be referred to as a side portion of the anode 221.

In the third embodiment of the present disclosure, the fourth area 321d of the anode 321 has a side mirror shape and thus can constitute a side mirror (SM) structure. In this case, for example, the SM structure of the anode 321 can reflect light, which is directed toward the fourth area 321d of the anode 321, in an upward direction (see the dashed arrows in FIG. 13) and thus form a reflective emission area EA2. Herein, for example, the reflective emission area EA2 follows an outline of the main emission area EA1. Further, when the light emitting element 320 emits light, the reflective emission area EA2 is shown as a continuous rectangular annular emission image or a discontinuous rectangular annular emission image. However, the present disclosure is not limited thereto. When the second opening OA2 has a polygonal shape, the reflective emission area EA2 can be shown as a polygonal annular emission image corresponding to the shape of the second opening OA2. When the reflective emission area EA2 is shown as a discontinuous rectangular annular emission image, it can have a discontinuous shape surrounding the outline of the main emission area EA1. For example, the annular shape of the reflective emission area EA2 can decrease in width or can be discontinuous as it gets closer to a corner of the main emission area EA1. A portion where the annular shape of the reflective emission area EA2 decreases in width or is discontinuous can have a greater width of the first non-emission area NEA1 than the other portion. This portion can show a lower luminance than a portion where the main emission area EA1 or the reflective emission area EA2 is continuous as the amount of light emitted from the light emitting element 320 and reflected from the SM structure decreases. The SM structure of the anode 321 causes an increase in the amount of light extraction. Thus, it is possible to improve the luminance and the optical efficiency. Meanwhile, the increase in the amount of light extraction facilitates low power consumption. Therefore, it is possible to reduce the use of fossil fuels for power generation and thus possible to reduce the emission of greenhouse gases. Accordingly, it is possible to implement ESG (Environment/Social/Governance). Further, the SM structure of the anode 321 is effective in improving the luminance viewing angles in all directions.

As described above, according to the third embodiment of the present disclosure, the side portion 170b of the structure 170 including a taper is disposed adjacent to the fourth area 321d having the SM structure. Thus, a greater amount of light emitted from an organic layer 322 collides with the fourth area 321d of the anode 321. Therefore, it is possible to further improve the front surface luminance. For example, the top surface 170a of the structure 170 is flat and the side portion 170b of the structure 170 including a taper is disposed adjacent to the fourth area 321d. Thus, the emitted light is reflected from the fourth area 321d so that the front surface luminance can be improved. Besides, the luminance viewing angle can also be improved by the taper of the side portion 170b of the structure 170.

Further, according to the third embodiment of the present disclosure, the top surface 170a of the structure 170 is flat. Thus, it is possible to increase the front surface luminance and also reduce the rainbow reflectance depending on reflection of external light. Therefore, the flat top surface 170a can be disposed in the central part A1 of the structure 170, and the side portion 170b including a taper can be disposed in the edge part A2.

In this case, the taper can have an angle of less than 30° to improve the color quality in the reflective emission area EA2. Further, the top surface of the second planarization layer 315b in contact with the side portion 170b can be flat to form a taper at the side portion 170b.

As described above, according to the third embodiment of the present disclosure, the main emission area EA1 can have an approximately rectangular shape. Further, the first non-emission area NEA1 can be shown as an emission image having an approximately rectangular annular shape surrounding the main emission area EA1. However, the present disclosure is not limited thereto. When the sub-pixel or the main emission area EA1 has a polygonal shape, the first non-emission area NEA1 can be shown as an emission image having a polygonal annular shape corresponding in shape to the sub-pixel or the main emission area EA1. Further, the reflective emission area EA2 can be shown as an emission image having a polygonal annular shape including a rectangular shape. Additionally, a second non-emission area NEA2 can be provided over the bank 316.

The bank 316 can be disposed to cover the anode 321.

The bank 316 can cover the third area 121c and the fourth area 321d of the anode 321. Further, the bank 316 can cover a part of the second area 321b of the anode 321.

A portion of the bank 316 can be opened corresponding to the main emission area EA1 of the sub-pixel.

For example, the bank 316 can include the first opening OA1 provided by removing (opening) a portion corresponding to the main emission area EA1 of each sub-pixel. For example, the second opening OA2 can have a greater width and a greater area than the first opening OA1. Further, the first opening OA1 can have a polygonal shape, such as a rectangular shape, when viewed from the top, but is not limited thereto. The first opening OA1 of the present disclosure can have various shapes, such as a circular shape or an oval shape. But is not limited thereto.

Meanwhile, the main emission area EA1 can correspond in shape to the first opening OA1. The correspondence of the shape of an element to the shape of another element can mean that the shape of the element is an identical shape to another element, two elements have an identical shape, but have different sizes from each other, or the shape of the element can be formed by transferring the shape of another element. Accordingly, the shape of the main emission area EA1 can mean that the shape of the first opening OA1 is substantially transferred by light emitted from the organic layer 322 located in the first opening OA1.

The reflective emission area EA2 does not overlap the main emission area EA1 and is located to surround the main emission area EA1.

The bank 316 can be disposed outside the structure 170. For example, the bank 316 can be disposed outside the structure 170 to be spaced apart from each other, but is not limited thereto.

The organic layer 322 can be disposed in the first opening OA1 of the bank 316.

A cathode 323 can be disposed on the organic layer 322.

The light emitting element 320 can be composed of the anode 321, the organic layer 322, and the cathode 323.

The encapsulation layer 140 can be located on the light emitting element 320 described above.

The encapsulation layer 140 can have a single layer structure or a multi-layer structure.

A touch sensor layer and/or a color filter layer and a black matrix can be disposed on the encapsulation layer 140.

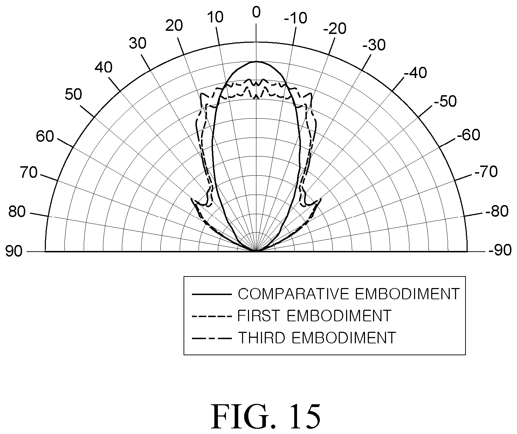

FIG. 15 is a graph showing a luminous intensity depending on a viewing angle.

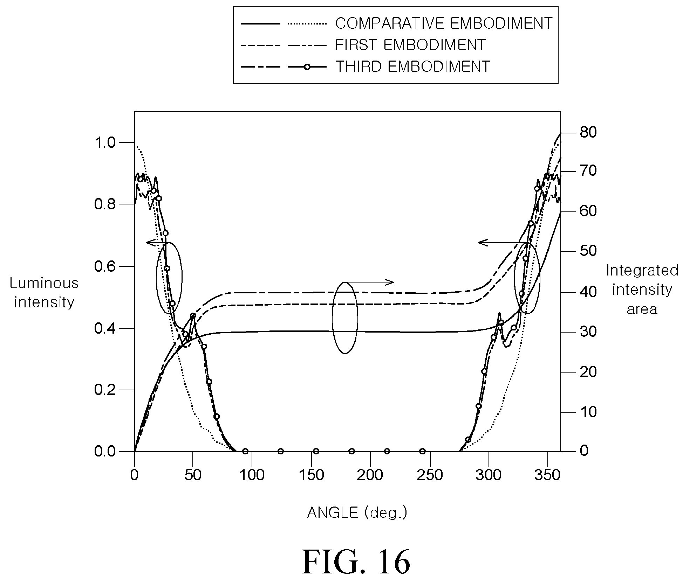

FIG. 16 is a graph for comparison with the graph in FIG. 15 in terms of a luminous intensity and an integrated intensity area depending on an angle.

Particularly, FIG. 15 and FIG. 16 are graphs showing simulation data according to the comparative embodiment, the first embodiment, and the third embodiment as an example.

In the comparative embodiment, a structure and an SM structure are not present. It can be seen that most of light is emitted through a micro cavity effect and to the front.

In the first embodiment, a structure is present, but an SM structure is not present. Thus, straight light can be emitted through a micro cavity and light is diagonally directed from the side portion of the tapered structure to improve the viewing angle.

In the third embodiment, a structure and an SM structure are present. The light reflected by the SM structure can also be observed along with the effect of the first embodiment.

Referring to FIG. 15, it can be seen that most of light travels straight due to a strong cavity effect in the comparative embodiment, whereas luminous intensities in a viewing angle direction are improved in the first and third embodiments.

When comparing the first embodiment with the third embodiment, it can be seen that the overall luminous intensity is higher when the SM structure is used.

FIG. 16 shows comparison with the graph in FIG. 15 in terms of a luminous intensity and an integrated intensity area depending on an angle. Herein, the solid line represents a graph in terms of a luminous intensity depending on an angle, and the dashed line represents a graph in terms of an integrated intensity area depending on an angle.

For example, FIG. 16 shows the graph of FIG. 15 at a viewing angle in the range of 0° to 360°. Referring to FIG. 16, it can be seen that as the viewing angle increases, the luminous intensity increases in the first and third embodiments as compared to the comparative embodiment.

Further, referring to the integrated intensity area data, the final values at 360° confirm that the overall luminous intensity is improved by about 23% in the first embodiment and about 32% in the third embodiment as compared to the comparative embodiment.

Meanwhile, when a single structure is used and requires a luminance viewing angle of 50° to 60°, an SM structure can be suitable. When the single structure requires a luminance viewing angle of 30° to 45°, a dual tapered structure can be suitable.

Hereinafter, a luminous intensity depending on an angle and a height of an SM structure will be described in detail with reference to a simulation result.

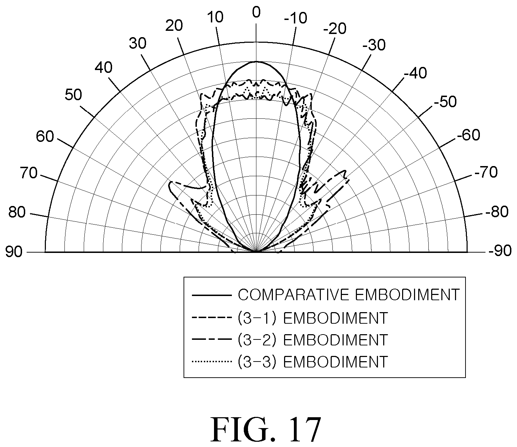

FIG. 17 is a graph showing a luminous intensity depending on a viewing angle.

Particularly, FIG. 17 is a graph showing simulation data according to the comparative embodiment, (3-1), (3-2) and (3-3) embodiments as an example.

Further, FIG. 17 illustrates a comparative embodiment without a structure and an SM structure. It can be seen that most of light is emitted through a micro cavity.

The third embodiment includes (3-1), (3-2) and (3-3) embodiments respectively including structures and SM structures with different angles of the SM structures. The light reflected by the SM structure can also be observed along with the effect of the first embodiment.

As described above, given the thickness variations of the organic layer, the side portion of the structure can include a taper having an angle of less than 30°.

As examples, in the (3-1) embodiment, the SM structure has an angle of 60°, in the (3-2) embodiment, the SM structure has an angle of 30°, and in the (3-3) embodiment, the SM structure has an angle of 20°. Further, in the (3-1), (3-2) and (3-3) embodiments, the SM structures have a thickness of 2 µm.

Referring to FIG. 17, it can be seen that most of light travels straight due to a strong micro cavity effect in the comparative embodiment, whereas luminous intensities in a viewing angle direction are improved and the overall luminous intensities are further increased in the (3-1), (3-2) and (3-3) embodiments.

It can be seen that the (3-1) embodiment where the SM structure has an angle of 60□ shows a decrease in front light extraction efficiency by about 10% as compared to the comparative embodiment. Further, it can be seen that the (3-1) embodiment shows an increase in front light extraction efficiency by about 3% as compared to the first embodiment.

It can be seen that the (3-2) embodiment where the SM structure has an angle of 30° shows a decrease in front light extraction efficiency by about 11.5% as compared to the comparative embodiment. Further, it can be seen that the (3-2) embodiment shows an increase in front light extraction efficiency by about 1.5% as compared to the first embodiment.

It can be seen that the (3-3) embodiment where the SM structure has an angle of 20° shows a decrease in front light extraction efficiency by about 13% as compared to the comparative embodiment. Further, it can be seen that the (3-3) embodiment shows a front light extraction efficiency equivalent to that of the first embodiment.

As described above, it can be seen that when the SM structure has an angle of 60°, an increase in front light extraction efficiency is not greater than when the SM structure has an angle of 30° or 20°. Further, it can be seen that when the SM structure has an angle of 20°, the luminance viewing angle is effectively improved. Further, the SM structure is effective in increasing the viewing angle as compared to the comparative embodiment, and can be set to 20° to 60°.

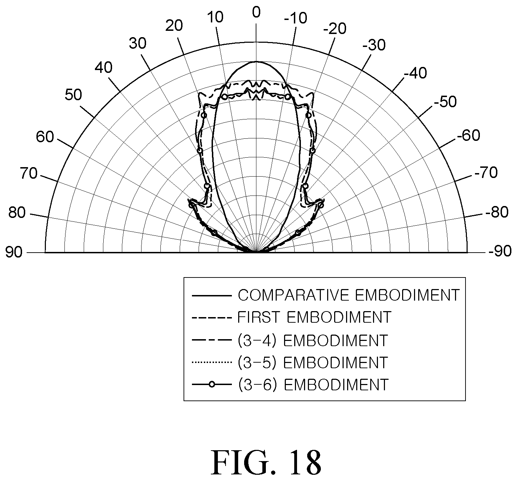

FIG. 18 is a graph showing a luminous intensity depending on a viewing angle.

Particularly, FIG. 18 is a graph showing simulation data according to the comparative embodiment, the first embodiment, and (3-4), (3-5) and (3-6) embodiments as an example.

Further, FIG. 18 illustrates the comparative embodiment without a structure and an SM structure. It can be seen that most of light is emitted through a micro cavity.

In the first embodiment, only a structure is present. Thus, straight light can be emitted through a micro cavity and light is diagonally directed from the side portion of the tapered structure to improve the viewing angle.

The third embodiment includes (3-4), (3-5) and (3-6) embodiments respectively including structures and SM structures with different heights of the SM structures. The light reflected by the SM structure can also be observed along with the effect of the first embodiment. Herein, the height of the SM structure can refer to the height from the top surface of the first planarization layer 315a to the third area 321c of the anode 321.

As examples, in the (3-4) embodiment, the SM structure has a height of 2 µm, in the (3-5) embodiment, the SM structure has a height of 1.0 µm, and in the (3-6) embodiment, the SM structure has a height of 0.5 µm. Further, in the (3-4), (3-5) and (3-6) embodiments, the SM structures have an angle of 60°.

Referring to FIG. 18, it can be seen that most of light travels straight due to a strong cavity effect in the comparative embodiment, whereas luminous intensities in a viewing angle direction are improved in the first embodiment. Further, the luminous intensities in a viewing angle direction are improved and the overall luminous intensities are further increased in the (3-4), (3-5) and (3-6) embodiments.

It can be seen that the (3-4) embodiment where the SM structure has a height of 2 µm shows a decrease in front light extraction efficiency by about 10% as compared to the comparative embodiment. Further, it can be seen that the (3-4) embodiment shows an increase in front light extraction efficiency by about 3% as compared to the first embodiment.

It can be seen that the (3-5) embodiment where the SM structure has a height of 1.0 µm shows a decrease in front light extraction efficiency by about 13% as compared to the comparative embodiment. Further, it can be seen that the (3-5) embodiment shows a front light extraction efficiency equivalent to that of the first embodiment.

It can be seen that the (3-6) embodiment where the SM structure has a height of 0.5 µm shows a decrease in front light extraction efficiency by about 13% as compared to the comparative embodiment. Further, it can be seen that the (3-6) embodiment shows a front light extraction efficiency equivalent to that of the first embodiment.

As described above, it can be seen that when the SM structure has a height of 0.5 µm or 1.0 µm, a similar result is obtained. Further, it can be seen that when the SM structure can improve the luminance viewing angle regardless of dimensions of the structure. Further, the SM structure can improve the front light extraction efficiency when the SM structure has a greater height than the structure.

Meanwhile, according to the present disclosure, the structure can be disposed in various shapes or manners. This will be described in detail with reference to the accompanying drawings.

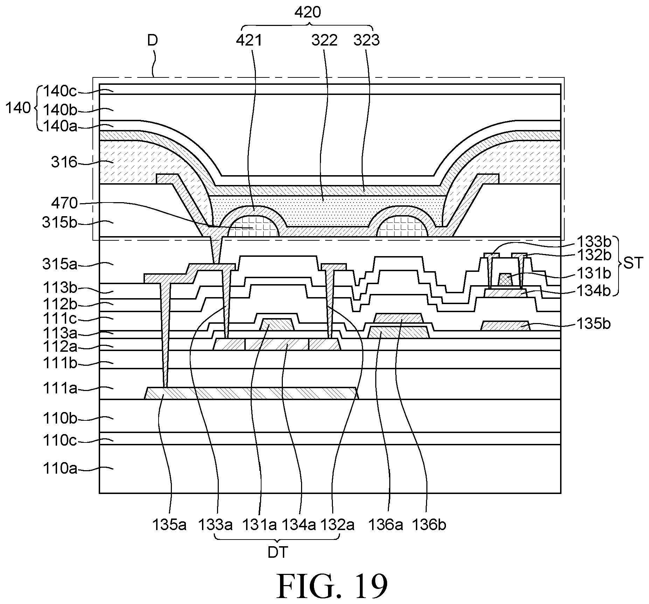

FIG. 19 is a cross-sectional view illustrating a part of a display panel according to a fourth embodiment of the present disclosure.

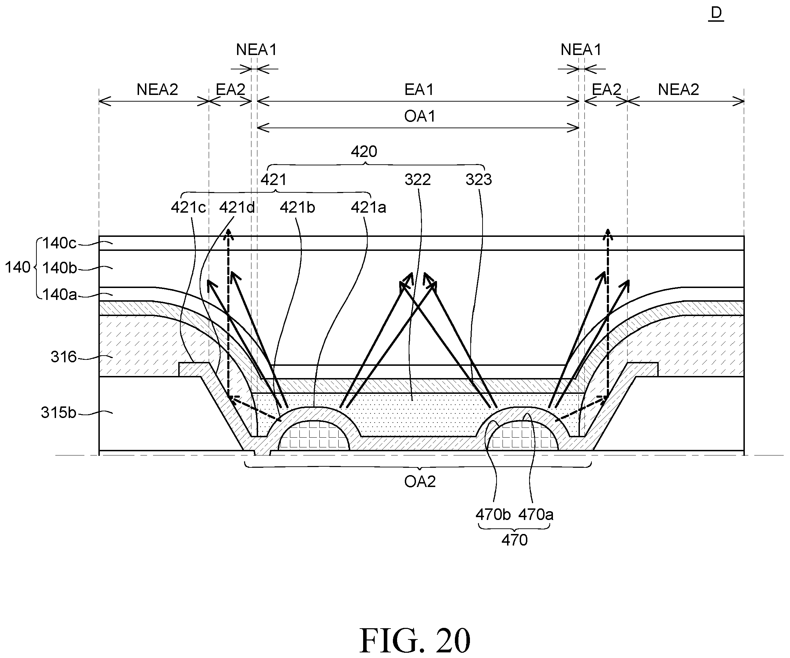

FIG. 20 is an enlarged view of the part D of FIG. 19.

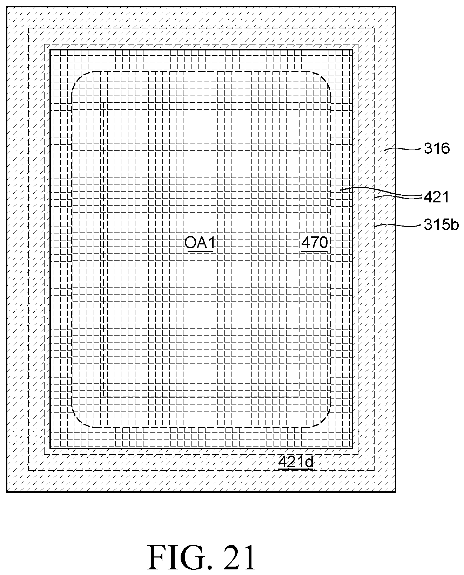

FIG. 21 is a diagram illustrating a planar surface structure of a sub-pixel in the display panel of FIG. 19.

Particularly, FIG. 19 and FIG. 20 are cross-sectional views of a sub-pixel as examples. The sub-pixel can include a touch sensor layer and/or a color filter layer and a black matrix on the encapsulation layer 140.

FIG. 21 illustrates a planar surface structure of a sub-pixel including the bank 316 having the first opening OA1, the second planarization layer 315b, a structure 470, and an anode 421 including a fourth area 421d on the structure 470.

The fourth embodiment shown in FIG. 19 through FIG. 21 is substantially the same as the third embodiment shown in FIG. 12 through FIG. 14 only except the shape and disposition of the structure 470. Therefore, redundant description of the same components will be omitted. Hereinafter, description of the same reference numerals can refer to FIG. 1 through FIG. 14.

Referring to FIG. 19 through FIG. 21, the driving transistor DT, the switching transistor ST, and a light emitting element 420 can be disposed on the substrates 110a, 110b and 110c according to the fourth embodiment of the present disclosure.

The first planarization layer 315a can be disposed on the substrates 110a, 110b and 110c.

The structure 470 can be disposed on the first planarization layer 315a.

The structure 470 according to the fourth embodiment of the present disclosure is disposed along an edge of the first opening OA1 and can have a frame shape with an open center. Further, the structure 470 according to the fourth embodiment of the present disclosure can have a flat top surface 470a and a side portion 470b including a taper and extending from the top surface 470a to a bottom surface. However, the present disclosure is not limited thereto. The top surface 470a may not be flat depending on a width of the top surface 470a.

The structure 470 has a frame shape. Thus, when viewed from the top, the structure 470 includes a left upper surface 470a disposed on the left side within the first opening OA1 and both side portions 470b, and can include a right upper surface 470a disposed on the right side and both side portions 470b. Further, for example, each of the left upper surface 470a and the both side portions 470b of the structure 470 and the right upper surface 470a and the both side portions 470b can be disposed adjacent to the edge of the first opening OA1.

For example, the side portion 470b of the structure 470 can include a taper having an angle of less than 30°.

For example, the structure 470 can have an approximately (or overall) polygonal frame shape, such as a rectangular frame shape, when viewed from the top, but is not limited thereto. The structure 470 of the present disclosure can have various frame shapes, such as a circular frame shape or an oval frame shape. But is not limited thereto.

As described above, according to the fourth embodiment of the present disclosure, the structure 470 including a taper having an angle of less than 30° is disposed at an edge under the light emitting element 420. Thus, the amount of diagonally directed light increases (see the solid arrows in FIG. 20). Therefore, it is possible to increase the front surface luminance and also improve the luminance viewing angle. When viewed from the top, the structure 470 has a greater number of side portions 470b (i.e., a greater number of tapers) in the fourth embodiment of the present disclosure than in the third embodiment. Thus, the amount of diagonally directed light further increases (see the solid arrows in the middle of FIG. 20). Therefore, it is possible to further improve the luminance viewing angle.

The second planarization layer 315b can be disposed on the first planarization layer 315a.

For example, the second planarization layer 315b can include the second opening OA2 provided by removing (opening) a portion corresponding to the main emission area EA1 and the first non-emission area NEA1 of the sub-pixel.

The structure 470 can be disposed within the second opening OA2.

The structure 470 can have a smaller height than the bank 316.

Further, the structure 470 can have a smaller height than the second planarization layer 315b.

For example, the anode 421 can be disposed on a part of the top surface and the side portion of the second planarization layer 315b, a part of the top surface of the first planarization layer 315a, and the top surface 470a and the side portion 470b of the structure 470. Further, for example, the top surface of the first planarization layer 315a can be exposed between the side portions 470b of the left upper surface 470a of the structure 470 and the side portions 470b of the right upper surface 470a when viewed from the top. Thus, the anode 421 can also be disposed on the exposed top surface of the first planarization layer 315a between the side portions 470b of the left upper surface 470a of the structure 470 and the side portions 470b of the right upper surface 470a.

For example, the anode 421 can include a first area 421a which is disposed on the top surface 470a of the structure 470 and whose surface is substantially parallel to a surface of the first planarization layer 315a. Further, the anode 421 can include a second area 421b which is disposed on the side portion 470b of the structure 470 and whose surface has a predetermined angle with respect to the first planarization layer 315a. For example, the second area 421b of the anode 421 can extend to the top surface of the first planarization layer 315a. The second area 421b of the anode 421 extending to the top surface of the first planarization layer 315a can have a flat top surface.

The first area 421a and the second area 421b of the anode 421 can correspond to the second opening OA2.

For example, the anode 421 can also include a third area 421c which is disposed on the top surface of the second planarization layer 315b and whose surface is substantially parallel to the surface of the second planarization layer 315b. The third area 421c can correspond to the top surface of the second planarization layer 315b.

For example, the anode 421 can further include the fourth area 421d which is disposed on the side portion of the second planarization layer 315b and whose surface has a predetermined angle with respect to the second planarization layer 315b. The fourth area 421d can be disposed between the second area 421b and the third area 421c.

In the same manner as in the third embodiment, the fourth area 421d of the anode 421 can constitute an SM (Side Mirror) structure. In this case, for example, the SM structure of the anode 421 can reflect light, which is directed toward the fourth area 421d of the anode 421, in an upward direction (see the dashed arrows in FIG. 20) and thus form the reflective emission area EA2.

As described, according to the fourth embodiment of the present disclosure, the side portion 470b of the structure 470 including a taper is disposed adjacent to the fourth area 421d having the SM structure. Thus, a greater amount of light emitted from the organic layer 322 collides with the fourth area 421d of the anode 421. Therefore, it is possible to further improve the front surface luminance. Further, when viewed from the top, the structure 470 has a greater number of side portions 470b. Thus, the amount of diagonally directed light further increases. Therefore, it is possible to further improve the luminance viewing angle.

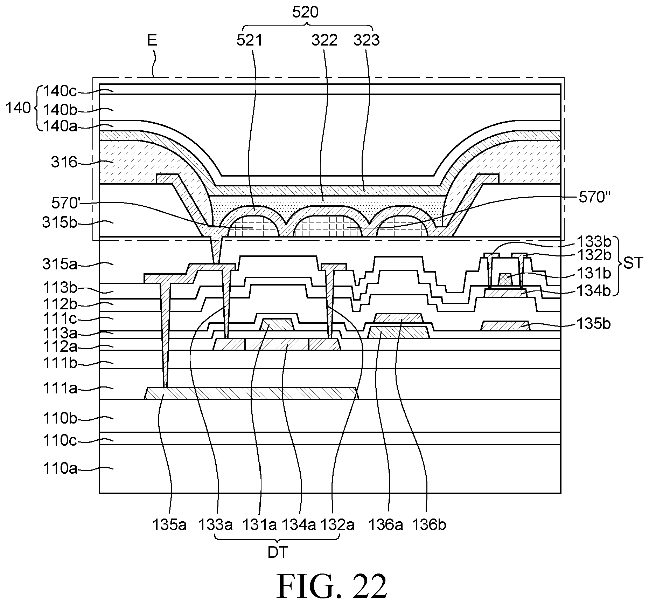

FIG. 22 is a cross-sectional view illustrating a part of a display panel according to a fifth embodiment of the present disclosure.

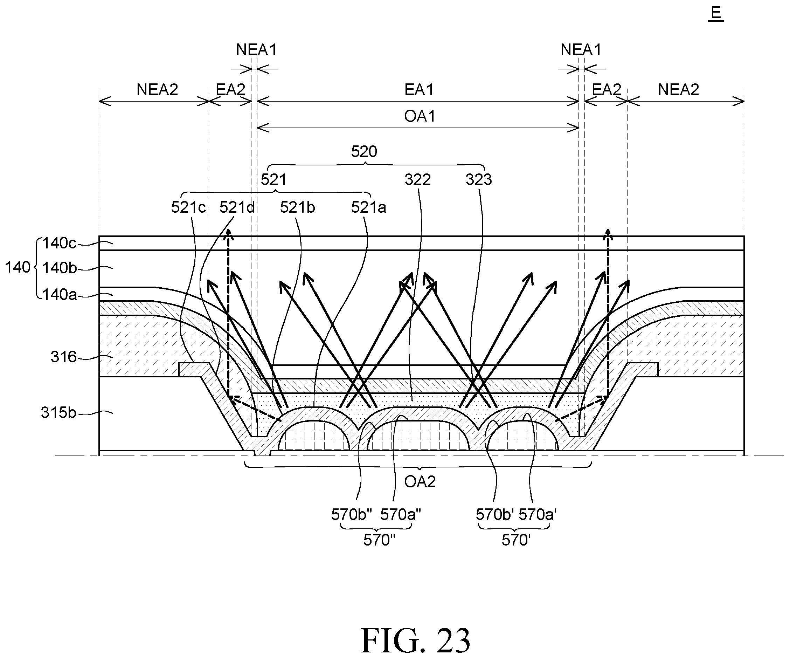

FIG. 23 is an enlarged view of the part E of FIG. 22.

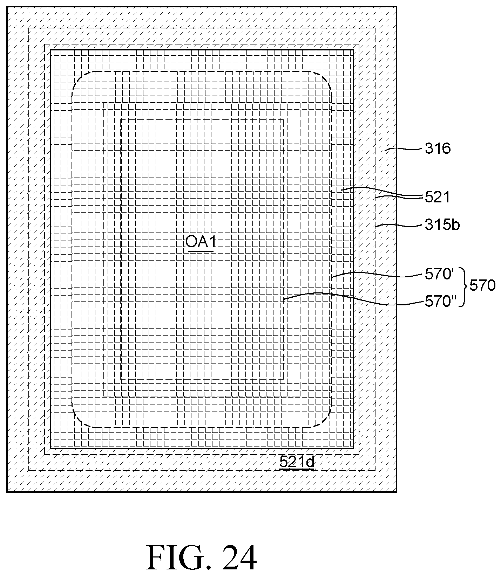

FIG. 24 is a diagram illustrating a planar surface structure of a sub-pixel in the display panel of FIG. 22.

Particularly, FIG. 22 and FIG. 23 are cross-sectional views of a sub-pixel as examples. The sub-pixel can include a touch sensor layer and/or a color filter layer and a black matrix on the encapsulation layer 140.

FIG. 24 illustrates a planar surface structure of a sub-pixel including the bank 316 having the first opening OA1, the second planarization layer 315b, a structure 570, and an anode 521 including a fourth area 521d on the structure 570.

The fifth embodiment shown in FIG. 22 through FIG. 24 is substantially the same as the third embodiment shown in FIG. 12 through FIG. 14 only except the shape and disposition of the structure 570. Therefore, redundant description of the same components will be omitted. Hereinafter, description of the same reference numerals can refer to FIG. 1 through FIG. 21.

Referring to FIG. 22 through FIG. 24, the structure 570 can be disposed on the first planarization layer 315a.

The structure 570 according to the fifth embodiment of the present disclosure can have a mixed structure of the structure of the first embodiment and the structure of the fourth embodiment. For example, the structure 570 according to the fifth embodiment of the present disclosure is disposed along the edge of the first opening OA1. Further, the structure 570 can include a first structure 570' having a frame shape with an open center and a second structure 570" disposed within the first structure 570'. Further, the first structure 570' and the second structure 570" of the structure 570 respectively have flat top surfaces 570a' and 570a" and side portions 570b' and 570b" each including a taper and extending from the top surfaces 570a' and 570a" to bottom surfaces. However, the present disclosure is not limited thereto. The top surface 570a' of the first structure 570' may not be flat depending on a width of the top surface 570a'.

For example, the first structure 570' has a frame shape. Thus, when viewed from the top, the first structure 570' includes a left first upper surface 570a' disposed on the left side within the first opening OA1 and both first side portions 570b', and can include a right first upper surface 570a' disposed on the right side and both first side portions 570b'. For example, each of the left first upper surface 570a' and the both first side portions 570b' of the first structure 570' and the right first upper surface 570a' and the both first side portions 570b' can be disposed adjacent to the edge of the first opening OA1.

Further, for example, the first side portion 570b' of the first structure 570' can include a taper having an angle of less than 30°.

For example, the first structure 570' can have an approximately (or overall) polygonal frame shape, such as a rectangular frame shape, when viewed from the top, but is not limited thereto. The first structure 570' of the present disclosure can have various frame shapes, such as a circular frame shape or an oval frame shape.

The second structure 570" is disposed within the first structure 570'. Further, when viewed from the top, the second structure 570" can include a second top surface 570a" with a flat center and a second side portion 570b" including a taper having a predetermined angle at an edge portion and extending from the second top surface 570a" to a bottom surface.

Further, for example, the second side portion 570b" of the second structure 570" can include a taper having an angle of less than 30°.

Furthermore, the second structure 570" can have an approximately (or overall) polygonal shape, such as a rectangular shape, when viewed from the top, but is not limited thereto. The second structure 570" of the present disclosure can have various shapes, such as a circular shape or an oval shape. But is not limited thereto.

As described above, according to the fifth embodiment of the present disclosure, the first structure 570' including a taper is disposed at an edge under a light emitting element 520. Further, the second structure 570" including a taper is disposed within the first structure 570'. Thus, the amount of diagonally directed light increases (see the solid arrows in FIG. 23). Therefore, it is possible to increase the front surface luminance and also improve the luminance viewing angle. In particular, when viewed from the top, the first structure 570' and the second structure 570" have a greater number of first side portions 570b' and second side portions 570b" each including a taper in the fifth embodiment of the present disclosure than in the third and fourth embodiments. Thus, the amount of diagonally directed light further increases (see the solid arrows in the middle of FIG. 23). Therefore, it is possible to further improve the luminance viewing angle.

The second planarization layer 315b can be disposed on the first planarization layer 315a.

For example, the anode 521 can be disposed on a part of the top surface and the side portion of the second planarization layer 315b, a part of the top surface of the first planarization layer 315a, and the first upper surfaces 570a' and the first side portions 570b' of the first structures 570' on both sides. Further, for example, the anode 521 can be disposed on the second top surface 570a" and the second side portion 570b" of the second structure 570" within the first structure 570'. Furthermore, the anode 521 can be disposed on the exposed top surface of the first planarization layer 315a between the first side portion 570b' of the first structure 570' and the second side portion 570b" of the second structure 570".

For example, the anode 521 can include a first area 521a which is disposed on the first upper surface 570a' of the first structure 570' and the second top surface 570a" of the second structure 570" and whose surface is substantially parallel to the surface of the first planarization layer 315a. Further, the anode 521 can include a second area 521b which is disposed on the first side portion 570b' of the first structure 570' and the second side portion 570b" of the second structure 570" and whose surface has a predetermined angle with respect to the first planarization layer 315a. For example, the second areas 521b on both sides of the anode 521 can extend to the top surface of the first planarization layer 315a. The second area 521b of the anode 521 extending to the top surface of the first planarization layer 315a can have a flat top surface.

The first area 521a and the second area 521b of the anode 521 can correspond to the second opening OA2.

For example, the anode 521 can also include a third area 521c which is disposed on the top surface of the second planarization layer 315b and whose surface is substantially parallel to the surface of the second planarization layer 315b.

For example, the anode 521 can further include the fourth area 521d which is disposed on the side portion of the second planarization layer 315b and whose surface has a predetermined angle with respect to the second planarization layer 315b.

In the same manner as in the third and fourth embodiments, the fourth area 521d of the anode 521 can constitute an SM structure. For example, the SM structure of the anode 521 can reflect light, which is directed toward the fourth area 521d of the anode 521, in an upward direction (see the dashed arrows in FIG. 23) and thus form the reflective emission area EA2.

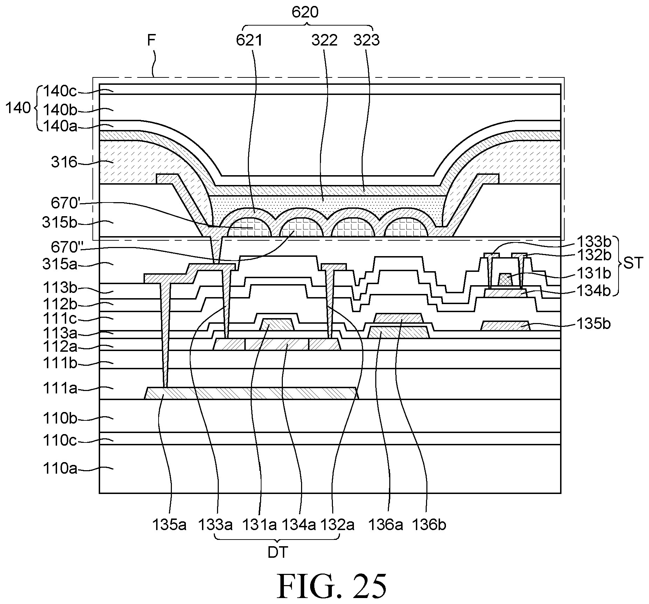

FIG. 25 is a cross-sectional view illustrating a part of a display panel according to a sixth embodiment of the present disclosure.

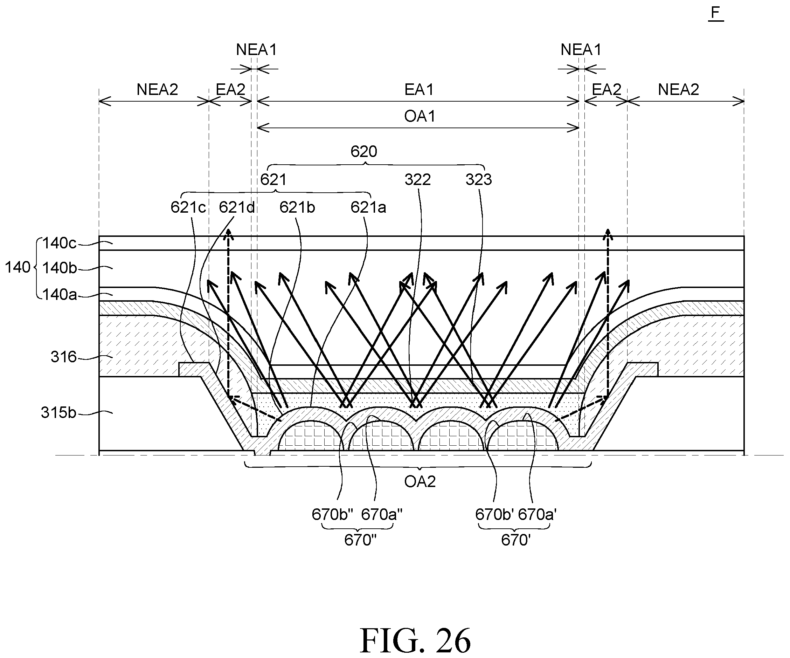

FIG. 26 is an enlarged view of the part F of FIG. 25.

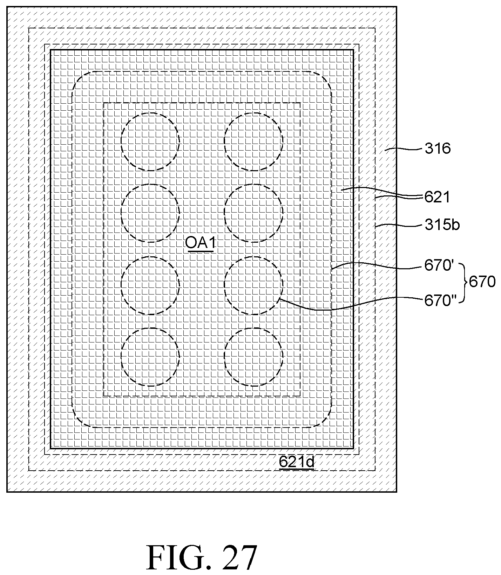

FIG. 27 is a diagram illustrating a planar surface structure of a sub-pixel in the display panel of FIG. 25.

Particularly, FIG. 25 and FIG. 26 are cross-sectional views of a sub-pixel as examples. The sub-pixel can include a touch sensor layer and/or a color filter layer and a black matrix on the encapsulation layer 140.

FIG. 27 illustrates a planar surface structure of a sub-pixel including the bank 316 having the first opening OA1, the second planarization layer 315b, a structure 670, and an anode 621 including a fourth area 621d on the structure 670.

The sixth embodiment shown in FIG. 25 through FIG. 27 is substantially the same as the third embodiment shown in FIG. 12 through FIG. 14 only except the shape and disposition of the structure 670. Therefore, redundant description of the same components will be omitted. Hereinafter, description of the same reference numerals can refer to FIG. 1 through FIG. 24.

Referring to FIG. 25 through FIG. 27, the structure 670 can be disposed on the first planarization layer 315a.

The structure 670 according to the sixth embodiment of the present disclosure is disposed along the edge of the first opening OA1. The structure 670 can include a first structure 670' having a frame shape with an open center and a plurality of second structures 670" disposed within the first structure 670'. For example, the first structure 670' and the second structures 670" of the structure 670 respectively have flat top surfaces 670a' and 670a" and side portions 670b' and 670b" each including a taper and extending from the top surfaces 670a' and 670a" to bottom surfaces. However, the present disclosure is not limited thereto. The top surfaces 670a' and 670a" may not be flat depending on widths of the top surfaces 670a' and 670a".

For example, the first structure 670' has a frame shape. Thus, when viewed from the top, the first structure 670' can include a left first upper surface 670a' disposed on the left side within the first opening OA1 and both first side portions 670b', and can include a right first upper surface 670a' disposed on the right side and both first side portions 670b'. For example, each of the left first upper surface 670a' and the both first side portions 670b' of the first structure 670' and the right first upper surface 670a' and the both first side portions 670b' can be disposed adjacent to the edge of the first opening OA1.

Further, for example, the first side portion 670b' of the first structure 670' can include a taper having an angle of less than 30°, but is not limited thereto.

For example, the first structure 670' can have an approximately (or overall) polygonal frame shape, such as a rectangular frame shape, when viewed from the top, but is not limited thereto. The first structure 670' of the present disclosure can have various frame shapes, such as a circular frame shape or an oval frame shape.

Each of the second structure 670" is disposed within the first structure 670'. Further, when viewed from the top, each second structure 670" includes a second top surface 670a" with a flat center and a second side portion 670b" including a taper at an edge portion and extending from the second top surface 670a" to a bottom surface. However, the present disclosure is not limited thereto. The second top surface 670a" may not be flat depending on a width of the second top surface 670a".

Further, for example, the second side portion 670b" of the second structure 670" can include a taper having an angle of less than 30°, but is not limited thereto.

Furthermore, each of the second structures 670" can have a circular shape or an oval shape, when viewed from the top, but is not limited thereto. Each of the second structures 670" of the present disclosure can have various shapes, such as a polygonal shape, but is not limited thereto, such as concentric shapes.

As described above, according to the sixth embodiment of the present disclosure, the first structure 670' including a taper is disposed at an edge under a light emitting element 620. Further, the plurality of second structures 670" including a taper is disposed within the first structure 670'. Thus, the amount of diagonally directed light increases to the maximum (see the solid arrows in FIG. 26). Therefore, it is possible to increase the front surface luminance and luminance viewing angle to the maximum. In particular, when viewed from the top, the first structure 670' and the plurality of second structures 670" have a greater number of first side portions 670b' and second side portions 670b" each including a taper in the sixth embodiment of the present disclosure than in the third, fourth and fifth embodiments. Thus, the amount of diagonally directed light further increases (see the solid arrows in the middle of FIG. 26). Therefore, it is possible to further improve the luminance viewing angle.

The second planarization layer 315b can be disposed on the first planarization layer 315a.

For example, the anode 621 can be disposed on a part of the top surface and the side portion of the second planarization layer 315b, a part of the top surface of the first planarization layer 315a, and the first upper surfaces 670a' and the first side portions 670b' of the first structures 670' on both sides. Further, for example, the anode 621 can be disposed on the second top surfaces 670a" and the second side portions 670b" of the plurality of second structures 670" within the first structure 670'. Furthermore, the anode 621 can be disposed on the exposed top surface of the first planarization layer 315a between the first side portion 670b' of the first structure 670' and the second side portions 670b" of the plurality of second structures 670".

For example, the anode 621 can include a first area 621a which is disposed on the first upper surface 670a' of the first structure 670' and the second top surfaces 670a" of the plurality of second structures 670" and whose surface is substantially parallel to the surface of the first planarization layer 315a. Further, the anode 621 can include a second area 621b which is disposed on the first side portion 670b' of the first structure 670' and the second side portions 670b" of the plurality of second structures 670" and whose surface has a predetermined angle with respect to the first planarization layer 315a. For example, the second areas 621b on both sides of the anode 621 can extend to the top surface of the first planarization layer 315a. The second area 621b of the anode 621 extending to the top surface of the first planarization layer 315a can have a flat top surface. In other embodiments, the first structure 670' need not a closed loop shape, but can be disconnected. For example, the first structure 670' can be formed of four parts, with two parts being parallel to each other and extending horizontally in FIG. 27, and two parts being parallel to each other and extending vertically in FIG. 27, but is not limited thereto. The number and extending directions of the parts of the first structure 670' can vary.

The first area 621a and the second area 621b of the anode 621 can correspond to the second opening OA2.

For example, the anode 621 can also include a third area 621c which is disposed on the top surface of the second planarization layer 315b and whose surface is substantially parallel to the surface of the second planarization layer 315b.

For example, the anode 621 can further include the fourth area 621d which is disposed on the side portion of the second planarization layer 315b and whose surface has a predetermined angle with respect to the second planarization layer 315b.

In the same manner as in the third, fourth and fifth embodiments, the fourth area 621d of the anode 621 can constitute an SM structure. For example, the SM structure of the anode 621 can reflect light, which is directed toward the fourth area 621d of the anode 621, in an upward direction (see the dashed arrows in FIG. 26) and thus form the reflective emission area EA2.

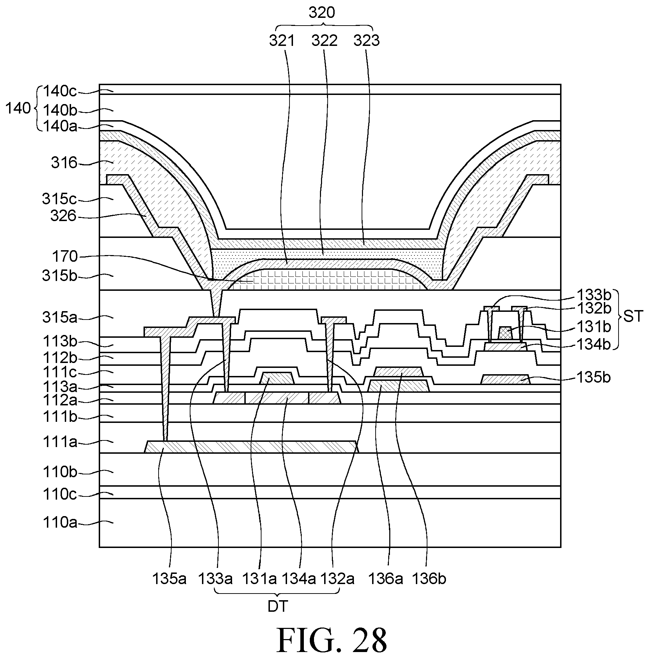

FIG. 28 is an enlarged partial cross-sectional view illustrating a part of a display panel according to a seventh embodiment of the present disclosure.

Particularly, FIG. 28 illustrates a variation of a structure 170 that can be formed by a conductive material, such as a material of the anode 121. The seventh embodiment shown in FIG. 28 is substantially the same as the embodiment shown in FIG. 4 and FIG. 26 except the structure and characteristics of the structure 170. Therefore, redundant description of the same components will be omitted. Hereinafter, the description of the same reference numerals may refer to FIG. 1 through FIG. 27.

With reference to FIG. 28, the anode 121 can be formed on the structure 170. The anode 121 can be formed on an upper surface of the structure 170, on an inclined surface of the second planarization layer 315b and on an inclined surface of a third planarization layer 315c. The structure 170 can include a conductive material such as the same material as that of the anode 121. When the structure 170 and the anode are formed of the same material, a portion of the anode 121 can be a multilayered structure. In various embodiments, the conductive material for the structure 170 can be different from that of the anode 121. Additionally, the structure 170 itself can be formed of a plurality of layers, whereby each of the plurality of layers can be a stacking of the same material or can be of different materials. For example, each of the plurality of layers can be formed of a conductive material, an insulative material, or the plurality of layers can be a combination of conductive materials and insulative materials, but is not limited thereto.

Also, with reference to FIG. 28, the anode 121 can further include a side mirror structure along with an auxiliary side mirror structure 326 on an inclined portion of the third planarization layer 315c. A connection portion that is on a level portion of the second planarization layer 315b need not be flat, and can be rounded or angled to allow light from emission area EA to reach and reflect off of the auxiliary side mirror structure 326. An angle of the auxiliary side mirror structure 326 can be the same or different from that of the side mirror structure.

In various embodiments of the present disclosure, an angle of incline of the inclined portion of the third planarization layer 315c can be different from an angle of incline of the inclined portion of the second planarization layer 315b, but is not limited thereto. For example, the angle of incline of the inclined portion of the third planarization layer 315c can be the same as the angle of incline of the inclined portion of the second planarization layer 315b. Also, the inclined portion of the third planarization layer 315c can be directly connected to the inclined portion of the second planarization layer 315b without a curved portion or a flat portion therebetween.

With reference to FIG. 28, the bank 316 can be disposed on an upper surface of the third planarization layer 315c and on the auxiliary side mirror structure 326. In embodiments of the present disclosure, an outer surface of the bank 316 facing toward the encapsulation layer 140 can be convex. When convex, the outer surface of the bank 316 can be curved, but is not limited thereto. For example, the outer surface of the bank 316 can be planar and inclined at an angle that corresponds to at least one of the angle of incline of the inclined portion of the third planarization layer 315c and the angle of incline of the inclined portion of the second planarization layer 315b, but is not limited thereto.

With reference to FIG. 28, the cathode 323 can be disposed on the bank 316 and the organic layer 322. The organic layer 322 can be exposed by the bank 316 on opposite ends of the organic layer 322 in the emission area EA. An uppermost surface of the bank 316 can be higher than an uppermost surface of the structure 170. In various embodiments of the present disclosure, a height (or a thickness) of the second planarization layer 315b can be different than a height (or a thickness) of the structure 170. For example, the height (or the thickness) of the second planarization layer 315b can be greater than the height (or the thickness) of the structure 170, but is not limited thereto, and the height (or the thickness) of the second planarization layer 315b can be equal to or less than the height (or the thickness) of the structure 170.

In various embodiments of the present disclosure, light emitting element 320 can emit light in a first direction that can be perpendicular to the substrate (110a, 110b and 110c), and a second direction that is angled to the substrate (110a, 110b and 110c). Also, a reflecting structure such as a mirror structure and/or an auxiliary mirror structure can reflect the light in a third direction that is different from the first direction and the second direction.

The example embodiments of the present disclosure can also be described as follows:

A display device can include a substrate including a plurality of sub-pixels; a first planarization layer disposed on the substrate; a structure disposed on the first planarization layer and having a tapered side portion; an anode disposed on the structure and the first planarization layer; a bank disposed on a part of the anode and having a first opening; an organic layer to emit light, and being exposed through the first opening and disposed on the anode; and a cathode disposed on the organic layer.

The structure can include a planar portion that is parallel to the substrate, and the tapered side portion is located at a periphery of the planar portion.

The planar portion has a height greater than that of the tapered side portion.

A groove is formed in the first planarization layer, and a portion of the anode is located in the groove.

An end of the tapered side portion is in the groove.

The first opening is rectangular.

A portion of the anode extends between the first planarization layer and the bank.

The tapered side portion includes a taper having an angle of less than 30°.

The taper has a width that is approximately 2 µm to 6 µm.

The taper is disposed under a light emitting element including the anode, the organic layer and the cathode.

The structure has a smaller height than the bank.

The structure includes a curved top surface disposed under the light emitting element.

The anode has a side mirror structure.

An end of the side mirror structure is disposed between the bank and first planarization layer.

An angle of the side mirror structure is approximately 30° to 60°, and an angle of the taper is less than the angle of the side mirror structure.

The structure includes a plurality of structures that are separated from each other.

The plurality of structure includes a first structure, and a second structure that encircles the first structure.

At least one of the first and second structures includes an insulating material.

The insulating material has a hardness that is greater than that of the first planarization layer.

A second planarization layer is on the first planarization layer, and an end of the anode is on the second planarization layer.

A second opening is in the second planarization layer, and the second opening is greater in size than a first opening of the first planarization layer.

According to an embodiment, a display device can include: a substrate including a plurality of sub-pixels; a planarization layer on the substrate; a structure on the planarization layer and having a tapered side portion; and a light emitting element on the structure, and configured to emit light, wherein the light emitting element emits light in a first direction that is perpendicular to the substrate, and a second direction that is angled to the substrate.

The display device can include a reflecting structure to reflect the light in a third direction that is different from the first direction and the second direction.

Although the embodiments of the disclosure have been described in detail with reference to the accompanying drawings, the disclosure is not limited thereto and can be embodied in many different forms without departing from the technical concept of the disclosure. Therefore, the embodiments of the disclosure are provided for illustrative purposes only but not intended to limit the technical concept of the disclosure. The scope of the technical concept of the disclosure is not limited thereto. Therefore, it should be understood that the above-described embodiments are illustrative in all aspects and do not limit the disclosure. All the technical concepts in the equivalent scope of the disclosure should be construed as falling within the scope of the disclosure.

## Claims

1. A display device comprising:
a substrate (110a, 110b, 110c) including a plurality of sub-pixels (P);
a first planarization layer (115a) on the substrate (110a, 110b, 110c);
a structure (170) on the first planarization layer (115a) and having a tapered side portion (170b);
a light emitting element (120) on the structure (170), and configured to emit light,
wherein the light emitting element (120) is configured to emit light in a first direction that is perpendicular to the substrate (110a, 110b, 110c), and a second direction that is angled to the substrate (110a, 110b, 110c).

2. The display device of claim 1, wherein the light emitting element (120) includes an anode (121) disposed on the structure (170) and the first planarization layer (115a); an organic layer (122) to emit light and disposed on the anode (121); and a cathode (123) disposed on the organic layer (122).

3. The display device of claim 2, further comprising a bank (116) disposed on a part of the anode (121) and having a first opening (OA1), the organic layer (122) being exposed through the first opening (OA1), preferably the first opening (OA1) is rectangular.

4. The display device of any one of the preceding claims, wherein the structure (170) further includes a planar portion that is parallel to the substrate (110a, 110b, 110c), wherein the tapered side portion (170b) is located at a periphery of the planar portion, preferably the planar portion has a height greater than that of the tapered side portion (170b).

5. The display device of any one of the preceding claims 2-4, further comprising a groove (H) formed in the first planarization layer (115a), wherein a portion of the anode (121) is located in the groove (H), preferably an end of the tapered side portion (170b) is in the groove (H).

6. The display device of any one of the preceding claims 3-5, wherein a portion of the anode (121) extends between the first planarization layer (115a) and the bank (116).

7. The display device of any one of the preceding claims, wherein the tapered side portion (170b) includes a taper having an angle of less than 30°, preferably the taper has a width that is approximately 2 µm to 6 µm and/or the taper is disposed under a light emitting element (120) including the anode (121), the organic layer (122) and the cathode (123).

8. The display device of any one of the preceding claims, wherein the structure (170) has a smaller height than the bank (116) and/or the structure (170) includes a curved top surface (170a) disposed under the light emitting element (120).

9. The display device of any one of the preceding claims, wherein the anode (121) has a side mirror structure (326), preferably an end of the side mirror structure (326) is disposed between the bank (116) and the first planarization layer (115a).

10. The display device of claim 9, wherein an angle of the side mirror structure (326) is approximately 30° to 60°, and/or an angle of the taper is less than the angle of the side mirror structure (326).

11. The display device of any one of the preceding claims, wherein the structure (170) includes a plurality of structures (570', 570'') that are separated from each other, preferably the plurality of structures includes a first structure (570'), and a second structure (570") that encircles the first structure (570'), preferably the structure (170) and/or at least one of the first and second structures (570', 570'') includes an insulating material.

12. The display device any one of the preceding claims, wherein the material of the structure (170), preferably an insulating material, has a hardness that is greater than that of the first planarization layer (115a).

13. The display device of any one of the preceding claims, further comprising a second planarization (315b) layer on the first planarization layer (315a), preferably an end of the anode (521) is on the second planarization layer (315b).

14. The display device of claim 13, further comprising a second opening (OA2) in the second planarization layer (315b), wherein the second opening (OA2) is greater in size than a first opening (OA1) of the first planarization layer (315a).

15. The display device any one of the preceding claims, further comprising a reflecting structure (326) to reflect the light in a third direction that is different from the first direction and the second direction.
